# EUROPEAN PATENT APPLICATION

(11) **EP 4 697 897 A1**
(43) Date of publication of application: **18.02.2026**
(21) Application number: 25196150.4
(22) Date of filing: 15.08.2025
(51) Int. Cl.: H10D 86/40, H10D 86/60, H10K 59/12, H10K 59/121

(54) **DISPLAY APPARATUS AND METHOD OF MANUFACTURING THE SAME**

(30) Priority: 16.08.2024 KR 20240110008
(71) Applicant: Samsung Display Co., Ltd., Yongin-si, Gyeonggi-do 17113 (KR)
(72) Inventor: Kim, Daehyun, 17113 Yongin-si, Gyeonggi-do, (KR); Kim, Sunghwan, 17113 Yongin-si, Gyeonggi-do (KR); Kim, Mihae, 17113 Yongin-si, Gyeonggi-do (KR)
(74) Representative: Gulde & Partner

(57) **Abstract**

A display apparatus (1) includes a first transistor (T6) disposed on a substrate (100) and including a first semiconductor layer (A6) and a first gate electrode (G6) overlapping the first semiconductor layer (A6), the first semiconductor layer (A6) including a silicon semiconductor material, and a first capacitor (C1) disposed on the substrate (100), wherein the first capacitor (C1) includes a 1-1 electrode (C11) including a silicon semiconductor material, a 1-2 electrode (C12) overlapping the 1-1 electrode (C11), the 1-2 electrode (C12) and the first gate electrode (G6) disposed on a same layer and including a same material, and a 1-3 electrode (C13) overlapping the 1-2 electrode (C12).

## Description

### BACKGROUND

### 1. Technical Field

One or more embodiments relate to a display apparatus and a method of manufacturing the display apparatus.

### 2. Description of the Related Art

Display apparatuses visually display data. Display apparatuses are used as displays for small products such as mobile phones or are used as displays for large products such as televisions.

A display apparatus includes pixels that emit light by receiving an electrical signal to display an image to the outside. Each pixel includes a display element. For example, an organic light-emitting display apparatus includes an organic light-emitting diode (OLED) as a display element. In general, in an organic light-emitting display apparatus, a thin-film transistor and an OLED are formed on a substrate, and the OLED emits light by itself.

As display apparatuses have recently been used for various purposes, various designs have been developed to improve the quality of display apparatuses.

### SUMMARY

One or more embodiments include a display apparatus with improved reliability and quality and a method of manufacturing the display apparatus. However, the embodiments are examples and do not limit the scope of the disclosure.

Additional aspects will be set forth in part in the description which follows and, in part, will be apparent from the description, or may be learned by practice of the embodiments.

According to one or more embodiments, a display apparatus includes a first transistor disposed on a substrate and including a first semiconductor layer and a first gate electrode overlapping the first semiconductor layer, the first semiconductor layer including a silicon semiconductor material, and a first capacitor disposed on the substrate, wherein the first capacitor includes a 1-1 electrode including a silicon semiconductor material, a 1-2 electrode overlapping the 1-1 electrode, the 1-2 electrode and the first gate electrode disposed on a same layer and including a same material, and a 1-3 electrode overlapping the 1-2 electrode.

According to the embodiment, the 1-1 electrode of the first capacitor may be a doped layer including a silicon semiconductor material.

According to the embodiment, the 1-1 electrode and the first semiconductor layer may be integral with each other.

According to the embodiment, the 1-2 electrode may be disposed over the 1-1 electrode.

According to the embodiment, the 1-3 electrode may be disposed over the 1-2 electrode.

According to the embodiment, the display apparatus may further include a second transistor disposed on the first capacitor and may further include a second semiconductor layer and a second gate electrode overlapping the second semiconductor layer, the second semiconductor layer may include an oxide semiconductor material.

According to the embodiment, the display apparatus may further include a second capacitor disposed on the substrate, wherein the second capacitor may include a 2-1 electrode and a 2-2 electrode overlapping the 2-1 electrode, and the 2-1 electrode and the first gate electrode may be disposed on a same layer, and may comprise a same material.

According to the embodiment, the 2-2 electrode may be disposed over the 2-1 electrode.

According to the embodiment, the display apparatus may further include a 2-3 electrode disposed under the 2-1 electrode to overlap the 2-1 electrode.

According to the embodiment, the 2-3 electrode and the first semiconductor layer of the first transistor may include a same material and may be disposed on a same layer.

According to the embodiment, the 2-3 electrode may include a silicon semiconductor material.

According to the embodiment, the 2-3 electrode may be a doped layer including a silicon semiconductor material.

According to one or more embodiments, a method of manufacturing a display apparatus includes arranging, on a substrate, a 1-1 electrode-forming material (i.e., a material for forming a 1-1 electrode) of a first capacitor and a first semiconductor layer-forming material (i.e., a material for forming a first semiconductor layer), the 1-1 electrode-forming material of the first capacitor and a first semiconductor layer-forming material including a silicon semiconductor material, arranging a blocking layer on at least a part of the first semiconductor layer-forming material, and forming a 1-1 electrode of the first capacitor by doping the 1-1 electrode-forming material on which the blocking layer is not arranged.

According to the embodiment, the method may further include removing the blocking layer, may further include forming a first gate electrode on at least a part of the first semiconductor layer-forming material, and may further include forming a first semiconductor layer, by doping at least a part of the first semiconductor layer-forming material on which the first gate electrode is not arranged.

According to the embodiment, a first transistor may include the first semiconductor layer and the first gate electrode overlapping the first semiconductor layer.

According to the embodiment, the method may further include forming a 1-2 electrode on the 1-1 electrode of the first capacitor to overlap the 1-1 electrode.

According to the embodiment, the 1-2 electrode of the first capacitor and the first gate electrode may be disposed on a same layer and may include a same material.

According to the embodiment, the 1-1 electrode-forming material of the first capacitor and the first semiconductor layer-forming material may be disposed on a same layer.

According to the embodiment, the 1-1 electrode of the first capacitor and the first semiconductor layer may be integral with each other.

According to the embodiment, the method may further include forming a 1-3 electrode of the first capacitor on the 1-2 electrode of the first capacitor to overlap the 1-2 electrode.

According to one or more embodiments, an electronic device may include: a display apparatus including: a first transistor disposed on a substrate and comprising a first semiconductor layer and a first gate electrode overlapping the first semiconductor layer, the first semiconductor layer comprising a silicon semiconductor material; and a first capacitor disposed on the substrate, wherein the first capacitor may include: a 1-1 electrode comprising a silicon semiconductor material; a 1-2 electrode overlapping the 1-1 electrode, the 1-2 electrode and the first gate electrode disposed on a same layer and comprising a same material; and a 1-3 electrode overlapping the 1-2 electrode.

According to the embodiment, the 1-1 electrode of the first capacitor may be a doped layer comprising a silicon semiconductor material.

According to the embodiment, the 1-1 electrode and the first semiconductor layer may be integral with each other.

According to the embodiment, the 1-2 electrode may be disposed over the 1-1 electrode.

According to the embodiment, the 1-3 electrode may be disposed over the 1-2 electrode.

According to the embodiment, the electronic device may be at least one of televisions, notebook computers, monitors, advertisement boards, Internet of things (IoTs), portable electronic apparatuses including mobile phones, smartphones, tablet personal computers (PCs), mobile communication terminals, electronic organizers, electronic books, portable multimedia players (PMPs), navigations, ultra mobile personal computers (UMPCs), smartwatches, watchphones, glasses-type displays, head-mounted displays (HMDs), instrument panels for automobiles, center fascias for automobiles, or center information displays (CIDs) on a dashboard, room mirror displays of automobiles, and displays of an entertainment system on a backside of front seats in automobiles.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments will be more apparent from the following description taken in conjunction with the accompanying drawings, in which:
FIG. 1 is a schematic plan view illustrating a display apparatus, according to an embodiment;
FIG. 2 is a block diagram illustrating a display apparatus, according to an embodiment;
FIG. 3 is a schematic diagram illustrating a light-emitting diode, which is a light-emitting element corresponding to one pixel of a display apparatus, and a pixel circuit electrically connected to the light-emitting diode, according to an embodiment;
FIGS. 4 to 6 are schematic plan views illustrating a pixel circuit included in a display apparatus for each layer, according to an embodiment;
FIG. 7 is a schematic cross-sectional view taken along line I-I' of the display apparatus of FIG. 6;
FIGS. 8 to 12 are schematic plan views illustrating a pixel circuit included in a display apparatus for each layer, according to an embodiment;
FIG. 13 is a schematic plan view illustrating a blocking layer disposed on at least a part of a semiconductor layer-forming material;
FIGS. 14 to 17 are schematic cross-sectional views illustrating a method of manufacturing a transistor and a capacitor;
FIGS. 18 to 20 are schematic plan views illustrating a process of forming a pixel circuit included in a display apparatus, according to an embodiment;
FIG. 21 is a schematic cross-sectional view taken along line III-III' of the display apparatus of FIG. 20;
FIG. 22 is a schematic plan view illustrating a blocking layer disposed on at least a part of a semiconductor layer;
FIGS. 23 to 25 are schematic plan views illustrating part of a method of manufacturing a transistor, a first capacitor, and a second capacitor; and
FIGS. 26 and 27 are schematic perspective views illustrating application examples of electronic devices.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings, wherein the same or corresponding elements are denoted by the same reference numerals throughout and a repeated description thereof is omitted.

Although the terms "first," "second," etc. may be used to describe various elements, these elements should not be limited by these terms. These terms are only used to distinguish one element from another.

As used herein, the singular forms "a," "an," and "the" are intended to include the plural forms as well, unless the context clearly indicates otherwise.

It will be understood that the terms "including" and "having" are intended to indicate the existence of the features or elements described in the specification, and are not intended to preclude the possibility that one or more other features or elements may exist or may be added.

It will be further understood that, when a layer, region, or component is referred to as being "on" another layer, region, or component, it may be directly on the other layer, region, or component, or may be indirectly on the other layer, region, or component with intervening layers, regions, or components therebetween.

Sizes of components in the drawings may be exaggerated or reduced for convenience of explanation. For example, because sizes and thicknesses of components in the drawings are arbitrarily illustrated for convenience of explanation, embodiments are not limited thereto.

When a certain embodiment may be implemented differently, a specific process order may be different from the described order. For example, two consecutively described processes may be performed substantially at the same time or may be performed in an order opposite to the described order.

"A and/or B" is used herein to select only A, select only B, or select both A and B. "At least one of A and B" is used to select only A, select only B, or select both A and B.

It will be understood that when a layer, a region, or a component is referred to as being "connected" to another layer, region, or component, it may be "directly connected" to the other layer, region, or component and/or may be "indirectly connected" to the other layer, region, or component with other layers, regions, or components therebetween. For example, when a layer, a region, or a component is referred to as being "electrically connected," it may be directly electrically connected, and/or may be indirectly electrically connected with intervening layers, regions, or components therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

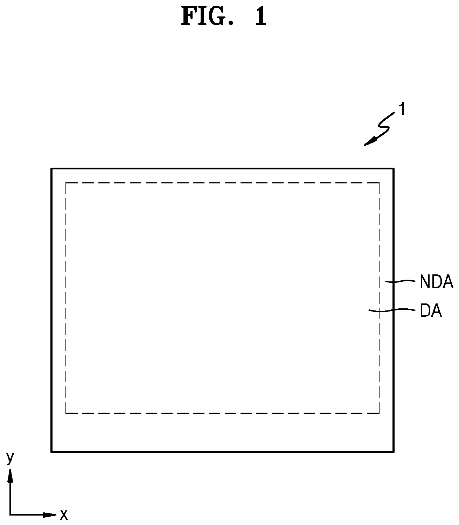

FIG. 1 is a schematic plan view illustrating a display apparatus, according to an embodiment.

Referring to FIG. 1, a display apparatus 1 may include a display area DA where an image is displayed and a non-display area NDA outside the display area DA. The display area DA may be surrounded (e.g., entirely surrounded) by the non-display area NDA.

In a plan view, the display area DA may have a rectangular shape. In another embodiment, the display area DA may have a polygonal shape (e.g., a triangular shape, a pentagonal shape, or a hexagonal shape), a circular shape, an elliptical shape, or an irregular shape. The display area DA may have a shape with round corners.

The display apparatus 1 may be a device for displaying a moving image or a still image and may be used in a portable electronic device such as a laptop, a tablet personal computer (PC), a mobile phone, a smartphone, a mobile communication terminal, an electronic organizer, an electronic book, a portable multimedia player (PMP), a navigation device, or an ultra-mobile PC (UMPC). In another example, the display apparatus 1 may be used in an electronic device such as a television, a monitor, an advertisement board, or an Internet of things (IoT) device or may be used in a wearable electronic device such as a smart watch, a watch phone, a glasses-type display, or a head-mounted display (HMD). For example, the display apparatus 1 according to an embodiment may be used for an instrument panel for a vehicle, a center information display (CID) located on a center fascia or a dashboard of a vehicle, a room mirror display replacing a side-view mirror of a vehicle, or for an electronic device for a display located on the back of a front seat for an entertainment for a person in a back seat of a vehicle.

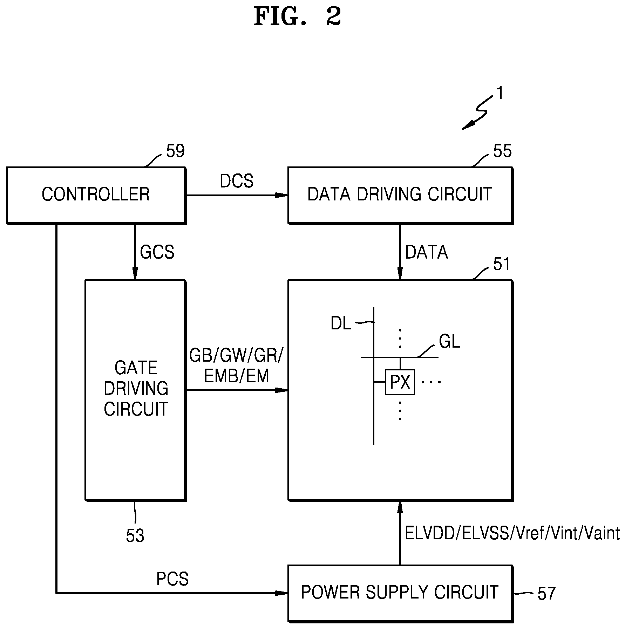

FIG. 2 is a schematic block diagram illustrating a display apparatus, according to an embodiment.

Referring to FIGS. 1 and 2, the display apparatus 1 according to an embodiment may include a pixel unit 51, a gate driving circuit 53, a data driving circuit 55, a power supply circuit 57, and a controller 59.

The pixel unit 51 may include pixels PX disposed in the display area DA (see FIG. 1). The pixels PX may be arranged in any of various shapes such as a stripe arrangement, a Pentile^{®} arrangement (or diamond arrangement), or a mosaic arrangement, to display an image. Each pixel PX may include a display element (e.g., a light-emitting diode), and the display element may be electrically connected to a pixel circuit. The pixels PX may display images by using light emitted from a display element corresponding to each pixel PX. Each pixel circuit may be electrically connected to a gate line GL and a data line DL, and may include multiple transistors and at least one capacitor.

In the non-display area NDA (see FIG. 1), various conductive lines for transmitting an electrical signal to be applied to the display area DA (see FIG. 1), outer circuits electrically connected to pixel circuits, and pads to which a printed circuit board or a driver integrated circuit (IC) chip is attached may be disposed. For example, in the non-display area NDA (see FIG. 1), the gate driving circuit 53, the data driving circuit 55, the power supply circuit 57, and the controller 59 may be provided or disposed.

The gate driving circuit 53 may be electrically connected to gate lines GL, and may generate a gate signal in response to a control signal GCS from the controller 59 and sequentially supply the gate signal to the gate lines GL. The gate signal may be a gate control signal used to turn on or turn off a transistor electrically connected to the gate line GL. The gate signal may be a square wave signal including an on-voltage for turning on the transistor and an off-voltage for turning off the transistor. In an embodiment, the on-voltage may be a high-level voltage (or first-level voltage) or a low-level voltage (or second-level voltage).

Although a pixel circuit corresponding to one pixel PX is connected to one gate line GL in FIG. 2, this is an example, and the pixel circuit corresponding to one pixel PX may be connected to two or more gate lines, and the gate driving circuit 53 may supply, to the gate lines, two or more gate signals having different timings at which an on-voltage is applied. For example, the pixel circuit may be connected to first to fifth gate lines, and the gate driving circuit 53 may respectively apply a first gate signal GW, a second gate signal GR, a third gate signal EM, a fourth gate signal GB, and a fifth gate signal EMB to the first gate lines, the second gate lines, the third gate lines, the fourth gate lines, and the fifth gate lines. The third gate signal EM may be an emission control signal used to turn on or turn off a transistor having a gate connected to the third gate line.

The data driving circuit 55 may be connected to data lines DL, and may supply a data signal to the data lines DL in response to a control signal DCS from the controller 59. The data signal supplied to the data line DL may be supplied to the pixel circuit. The data driving circuit 55 may convert input image data having a grayscale input from the controller 59 into a data signal in the form of a voltage or current.

The power supply circuit 57 may generate voltages required to drive the pixel PX in response to a control signal PCS from the controller 59. The power supply circuit 57 may generate a driving voltage ELVDD and a common voltage ELVSS and supply the driving voltage ELVDD and the common voltage ELVSS to the pixels PX. The driving voltage ELVDD may be a high-level voltage provided to a first electrode (e.g., pixel electrode or anode) of a display element included in the pixel PX. The common voltage ELVSS may be a low-level voltage provided to a second electrode (e.g., counter electrode or cathode) of the display element included in the pixel PX. The power supply circuit 57 may generate a reference voltage Vref, a first initialization voltage Vaint, and a second initialization voltage Vint and supply the reference voltage Vref, the first initialization voltage Vaint, and the second initialization voltage Vint to the pixels PX.

A voltage level of the driving voltage ELVDD may be higher than a voltage level of the common voltage ELVSS. A voltage level of the reference voltage Vref may be lower than a voltage level of the driving voltage ELVDD. A voltage level of the first initialization voltage Vaint may be higher than a voltage level of the second initialization voltage Vint. A voltage level of the second initialization voltage Vint may be lower than a voltage level of the common voltage ELVSS. A voltage level of the first initialization voltage Vaint may be equal to or higher than a voltage level of the common voltage ELVSS.

The controller 59 may generate the control signals GCS, DCS, and PCS based on signals input from the outside, and supply the control signals GCS, DCS, and PCS to the gate driving circuit 53, the data driving circuit 55, and the power supply circuit 57. The control signal GCS output to the gate driving circuit 53 may include clock signals and a gate start signal. The control signal DCS output to the data driving circuit 55 may include a source start signal and clock signals.

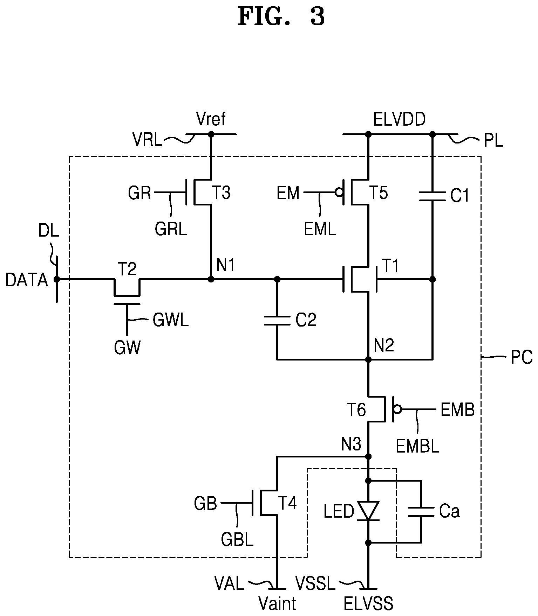

FIG. 3 is a schematic diagram illustrating a light-emitting diode, which is a light-emitting element corresponding to one pixel of a display apparatus, and a pixel circuit electrically connected to the light-emitting diode, according to an embodiment.

Referring to FIG. 3, some of the transistors included in a pixel circuit PC may be N-type transistors and others may be P-type transistors. First to fourth transistors T1, T2, T3, and T4 may be N-type transistors, and fifth and sixth transistors T5 and T6 may be P-type transistors. Semiconductor layers of the first to fourth transistors T1, T2, T3, and T4 may include a material different from that of semiconductor layers of the fifth and sixth transistors T5 and T6. In some embodiments, the semiconductor layer of the first to fourth transistors T1, T2, T3, and T4 may include an oxide, and the fifth and sixth transistors T5 and T6 may include amorphous silicon, polysilicon, or an organic semiconductor.

The pixel circuit PC may be electrically connected to a first gate line GWL transmitting the first gate signal GW, a second gate line GRL transmitting the second gate signal GR, a third gate line EML transmitting the third gate signal EM, a fourth gate line GBL transmitting the fourth gate signal GB, a fifth gate line EMBL transmitting the fifth gate signal EMB, and a data line DL transmitting the data signal DATA. Because light emission of a light-emitting diode LED is controlled by the third gate signal EM and the fifth gate signal EMB, the third gate signal EM and the fifth gate signal EMB may be emission control signals, and the third gate line EML and the fifth gate line EMBL may be emission control lines. For example, the pixel circuit PC may include a driving voltage line PL transmitting the driving voltage ELVDD, a reference voltage line VRL transmitting the reference voltage Vref, and a first initialization voltage line VAL transmitting the first initialization voltage Vaint.

In an embodiment, the transistors included in the pixel circuit PC may be N-type oxide transistors. The oxide transistor may be a transistor in which a semiconductor layer includes an oxide. However, this is an example, and the transistors of the disclosure are not limited thereto. For example, a semiconductor layer included in the N-type transistor may include an inorganic semiconductor (e.g., amorphous silicon or polysilicon) or an organic semiconductor.

The pixel circuit PC may include first to sixth transistors T1, T2, T3, T4, T5, and T6, first and second capacitors C1 and C2, and an auxiliary capacitor Ca. The first transistor T1 may be a driving transistor that outputs driving current corresponding to the data signal DATA, and the second to sixth transistors T2, T3, T4, T5, and T6 may be switching transistors that transmit signals. A first terminal (or a first electrode) and a second terminal (or a second electrode) of each of the first to sixth transistors T1, T2, T3, T4, T5, and T6 may be a source (or a source electrode) or a drain (or a drain electrode) according to voltages of the first terminal and the second terminal. For example, according to the voltages of the first terminal and the second terminal, the first terminal may be the drain and the second terminal may be the source, or the first terminal may be the source and the second terminal may be the drain. Hereinafter, a node to which a 1-1 gate electrode of the first transistor T1 is connected may be defined as a first node N1, and a node to which the second terminal of the first transistor T1 is connected may be defined as a second node N2.

The first transistor T1 may be connected between the driving voltage line PL and the light-emitting diode LED. The first transistor T1 may be connected between the fifth transistor T5 and the sixth transistor T6. The first transistor T1 may include a first gate (or a first gate electrode), a first terminal, and the second terminal connected to the second node N2. The first transistor T1 may include the 1-1 gate connected to the first node N1. The first transistor T1 may further include a 1-2 gate connected to the second terminal of the first transistor T1. The 1-1 gate and the 1-2 gate may be disposed on different layers to face each other. For example, the 1-1 gate and the 1-2 gate of the first transistor T1 may face each other with a semiconductor layer therebetween. In the description, the first gate (or the first gate electrode) of the first transistor T1 may refer to the 1-1 gate (or the 1-1 gate electrode) involved in turning-on and turning-off of the first transistor T1.

The gate (or the 1-1 gate) of the first transistor T1 may be connected to the second terminal of the second transistor T2, the first terminal of the third transistor T3, and the second capacitor C2. The 1-2 gate of the first transistor T1 may be connected to the first terminal of the sixth transistor T6, the first capacitor C1, and the second capacitor C2. The first terminal of the first transistor T1 may be connected to the driving voltage line PL via the fifth transistor T5, and the second terminal may be connected to a pixel electrode of the light-emitting diode LED via the sixth transistor T6. The first terminal of the first transistor T1 may be connected to the second terminal of the fifth transistor T5. The second terminal of the first transistor T1 may be connected to the first terminal of the sixth transistor T6, the first capacitor C1, and the second capacitor C2. The first transistor T1 may receive the data signal DATA according to a switching operation of the second transistor T2, and control the amount of driving current flowing to the light-emitting diode LED.

The second transistor T2 may be connected to the data line DL and the gate of the first transistor T1. The second transistor T2 may include a gate connected to the first gate line GWL, the first terminal connected to the data line DL, and the second terminal connected to the first node N1. The second terminal of the second transistor T2 may be connected to the gate of the first transistor T1, the first terminal of the third transistor T3, and the second capacitor C2. The second transistor T2 may be turned on according to the first gate signal GW transmitted through the first gate line GWL to electrically connect the data line DL to the first node N1, and may transmit the data signal DATA received through the data line DL to the first node N1.

The third transistor T3 may be connected to the gate of the first transistor T1 and the reference voltage line VRL. The third transistor T3 may include a gate connected to the second gate line GRL, the first terminal connected to the first node N1, and the second terminal connected to the reference voltage line VRL. The first terminal of the third transistor T3 may be connected to the gate of the first transistor T1, the second terminal of the second transistor T2, and the second capacitor C2. The third transistor T3 may be turned on according to the second gate signal GR transmitted through the second gate line GRL to transmit the reference voltage Vref received through the reference voltage line VRL to the first node N1.

The fourth transistor T4 may be connected to the sixth transistor T6 and the first initialization voltage line VAL. The fourth transistor T4 may be connected between the light-emitting diode LED and the first initialization voltage line VAL. The fourth transistor T4 may include a gate connected to the fourth gate line GBL, the first terminal connected to a third node N3, and the second terminal connected to the first initialization voltage line VAL. The first terminal of the fourth transistor T4 may be connected to the second terminal of the sixth transistor T6 and the pixel electrode of the light-emitting diode LED. The fourth transistor T4 may be turned on according to the fourth gate signal GB transmitted through the fourth gate line GBL to transmit the first initialization voltage Vaint received through the first initialization voltage line VAL to the third node N3, thereby initializing the pixel electrode (e.g., anode) of the light-emitting diode LED.

The fifth transistor T5 may be connected to the driving voltage line PL and the first transistor T1. The fifth transistor T5 may include a gate connected to the third gate line EML, the first terminal connected to the driving voltage line PL, and the second terminal connected to the first terminal of the first transistor T1. The fifth transistor T5 may be turned on or off according to the third gate signal EM transmitted through the third gate line EML.

The sixth transistor T6 may be connected to the first transistor T1 and the light-emitting diode LED. The sixth transistor T6 may be connected between the second node N2 and the third node N3. The sixth transistor T6 may include a gate connected to the fifth gate line EMBL, the first terminal connected to the second node N2, and the second terminal connected to the third node N3. The first terminal of the sixth transistor T6 may be connected to the second terminal of the first transistor T1, the first capacitor C1, and the second capacitor C2. The second terminal of the sixth transistor T6 may be connected to the first terminal of the fourth transistor T4 and the pixel electrode of the light-emitting diode LED. The sixth transistor T6 may be turned on or off according to the fifth gate signal EMB transmitted through the fifth gate line EMBL.

The first capacitor C1 may be connected between the gate of the first transistor T1 and the second terminal of the first transistor T1. A first electrode of the second capacitor C2 may be connected to the first node N1, and a second electrode of the second capacitor C2 may be connected to the second node N2. The first electrode of the second capacitor C2 may be connected to the gate of the first transistor T1, the second terminal of the second transistor T2, and the first terminal of the third transistor T3. The second electrode of the second capacitor C2 may be connected to the second terminal and the 1-2 gate of the first transistor T1, a second electrode of the first capacitor C1, and the first terminal of the sixth transistor T6. The second capacitor C2 may be a storage capacitor and may store a voltage corresponding to the data signal DATA and a threshold voltage of the second transistor T2.

In case that the third transistor T3 and the fifth transistor T5 are turned on, the first transistor T1 may be turned on. In case that a voltage of the second terminal of the first transistor T1 decreases to a difference (Vref-Vth1) between the reference voltage Vref and a threshold voltage Vth1 of the first transistor T1, the first transistor T1 may be turned off, and a voltage corresponding to the threshold voltage Vth1 of the first transistor T1 may be stored in the second capacitor C2 so that the threshold voltage Vth1 of the first transistor T1 may be compensated for.

The first capacitor C1 may be connected between the driving voltage line PL and the second node N2. A first electrode of the first capacitor C1 may be connected to the driving voltage line PL. The second electrode of the first capacitor C1 may be connected to the second terminal and the 1-2 gate of the first transistor T1, the second electrode of the second capacitor C2, and the first terminal of the sixth transistor T6.

Capacitances of the first capacitor C1 and the second capacitor C2 may vary according to a color of light emitted by the light-emitting diode LED.

The auxiliary capacitor Ca may be electrically connected to the sixth transistor T6, a sustain voltage line VSSL, and the pixel electrode of the light-emitting diode LED. The auxiliary capacitor Ca may store and sustain a voltage corresponding to a voltage difference between the pixel electrode of the light-emitting diode LED and the sustain voltage line VSSL, thereby preventing a black luminance from increasing in case that the sixth transistor T6 is turned off.

The light-emitting diode LED may be connected to the first transistor T1 through the sixth transistor T6. The light-emitting diode LED may include the pixel electrode (e.g., anode) connected to the third node N3 and a counter electrode (e.g., cathode) facing the pixel electrode, and the counter electrode may receive a common voltage ELVSS. In an embodiment, the counter electrode (e.g., cathode) may extend to a display area and may be electrically connected to the sustain voltage line VSSL that provides the common voltage ELVSS. Due to the fifth transistor T5 and the sixth transistor T6 which are turned on, driving current output by the first transistor T1 may flow through the light-emitting diode LED, and the light-emitting diode LED may emit light with a luminance corresponding to a magnitude of the driving current.

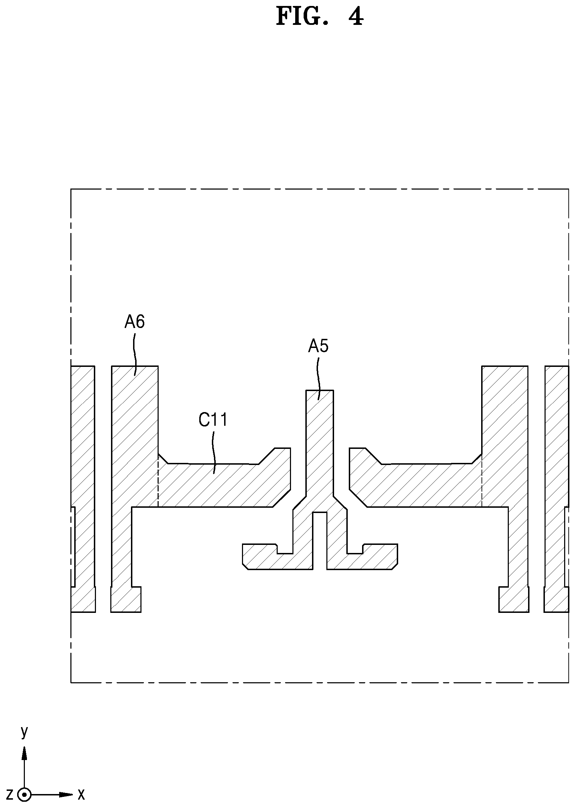

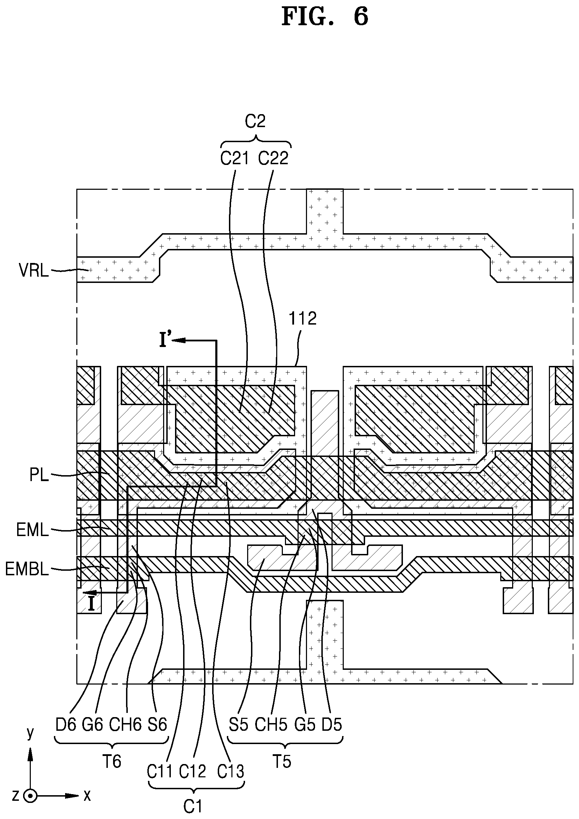

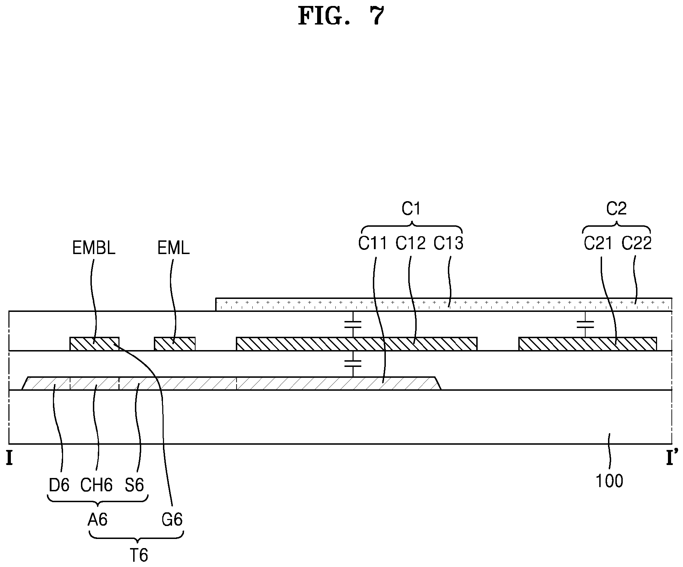

FIGS. 4 to 6 are schematic plan views illustrating a pixel circuit included in a display apparatus for each layer, according to an embodiment. FIG. 7 is a schematic cross-sectional view taken along line I-I' of the display apparatus of FIG. 6.

Referring to FIG. 4, a fifth semiconductor layer A5, a sixth semiconductor layer A6, and a 1-1 electrode C11 of the first capacitor C1 (see FIG. 6) may be disposed on a substrate 100 (see FIG. 7). For example, the fifth semiconductor layer A5, the sixth semiconductor layer A6, and the 1-1 electrode C11 of the first capacitor C1 may be disposed on the same layer. The fifth semiconductor layer A5, the sixth semiconductor layer A6, and the 1-1 electrode C11 of the first capacitor C1 may include the same material. For example, the fifth semiconductor layer A5, the sixth semiconductor layer A6, and the 1-1 electrode C11 of the first capacitor C1 may include a silicon semiconductor material. For example, the fifth semiconductor layer A5, the sixth semiconductor layer A6, and the 1-1 electrode C11 of the first capacitor C1 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In another embodiment, the fifth semiconductor layer A5, the sixth semiconductor layer A6, and the 1-1 electrode C11 of the first capacitor C1 may include polysilicon or amorphous silicon.

The sixth semiconductor layer A6 and the 1-1 electrode C11 of the first capacitor C1 may be integrally formed (or integral) with each other. For example, the sixth semiconductor layer A6 and the 1-1 electrode C11 of the first capacitor C1 may be integrally connected to each other. The fifth semiconductor layer A5 may be disposed adjacent to the sixth semiconductor layer A6 and the 1-1 electrode C11 of the first capacitor C1, but may be separated and spaced apart from the sixth semiconductor layer A6 and the 1-1 electrode C11 of the first capacitor C1.

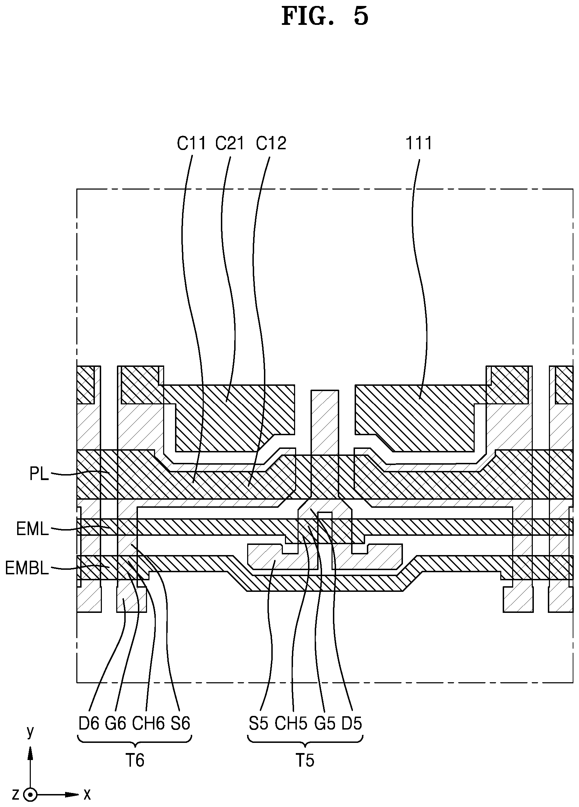

Referring to FIG. 5, the fifth gate electrode G5, the sixth gate electrode G6, the first conductive layer 111, the driving voltage line PL, the third gate line EML, the fifth gate line EMBL, a 1-2 electrode C12 of the first capacitor C1, and a 2-1 electrode C21 of a second capacitor C2 may be disposed on the fifth semiconductor layer A5, the sixth semiconductor layer A6, and the 1-1 electrode C11 of the first capacitor C1. The first conductive layer 111 may have an isolated shape. The driving voltage line PL, the third gate line EML, and the fifth gate line EMBL may extend in a first direction (e.g., a positive x direction or a negative x direction).

The fifth gate electrode G5, the sixth gate electrode G6, the first conductive layer 111, the driving voltage line PL, the third gate line EML, the fifth gate line EMBL, the 1-2 electrode C12 of the first capacitor C1, and the 2-1 electrode C21 of the second capacitor C2 may include the same material. For example, the fifth gate electrode G5, the sixth gate electrode G6, the first conductive layer 111, the driving voltage line PL, the third gate line EML, the fifth gate line EMBL, the 1-2 electrode C12 of the first capacitor C1, and the 2-1 electrode C21 of the second capacitor C2 may include molybdenum (Mo), aluminum (Al), copper (Cu), or titanium (Ti), and may have a single-layer structure or a multi-layer structure including the above material.

The driving voltage line PL may include the 1-2 electrode C12 of the first capacitor C1. The 1-2 electrode C12 of the first capacitor C1 may be a part of the driving voltage line PL. For example, the driving voltage line PL and the 1-2 electrode C12 of the first capacitor C1 may be integrally formed (or integral) with each other. The 1-2 electrode C12 of the first capacitor C1 may overlap the 1-1 electrode C11 of the first capacitor C1.

The first conductive layer 111 may include the 2-1 electrode C21 of the second capacitor C2. The 2-1 electrode C21 of the second capacitor C2 may be a part of the first conductive layer 111. For example, the first conductive layer 111 and the 2-1 electrode C21 of the second capacitor C2 may be integrally formed (or integral) with each other.

The third gate line EML may include the fifth gate electrode G5 overlapping a channel region CH5 of the fifth transistor T5. The fifth semiconductor layer A5 described with reference to FIG. 4 may include the channel region CH5 overlapping the fifth gate electrode G5, a source region S5 disposed on a side of the channel region CH5, and a drain region D5 disposed on another side of the channel region CH5.

The fifth gate line EMBL may include the sixth gate electrode G6 overlapping a channel region CH6 of the sixth transistor T6. The sixth semiconductor layer A6 described with reference to FIG. 4 may include the channel region CH6 overlapping the sixth gate electrode G6, a source region S6 disposed on a side of the channel region CH6, and a drain region D6 disposed on another side of the channel region CH6.

The fifth gate line EMBL may be disposed relatively far from the first conductive layer 111. In some embodiments, the driving voltage line PL and the third gate line EML may be disposed between the first conductive layer 111 and the fifth gate line EMBL.

Referring to FIG. 6, a reference voltage line VRL, a second conductive layer 112, a 1-3 electrode C13 of the first capacitor C1, and a 2-2 electrode C22 of the second capacitor C2 may be disposed on the fifth gate electrode, the sixth gate electrode, the first conductive layer 111, a driving voltage line ELVDD, the third gate line EML, the fifth gate line EMBL, the 1-2 electrode C12 of the first capacitor C1, and the 2-1 electrode C21 of the second capacitor C2.

The second conductive layer 112 may have an isolated shape. The reference voltage line VRL may extend in the first direction (e.g., the positive x direction or the negative x direction).

The second conductive layer 112 may include the 1-3 electrode C13 of the first capacitor C1. The 1-3 electrode C13 of the first capacitor C1 may be a part of the second conductive layer 112. For example, the second conductive layer 112 and the 1-3 electrode C13 of the first capacitor C1 may be integrally formed (or integral) with each other. The 1-3 electrode C13 of the first capacitor C1 may overlap the 1-1 electrode C11 and the 1-2 electrode C12. The first capacitor C1 may include the 1-1 electrode C11, the 1-2 electrode C12, and the 1-3 electrode C13.

The second conductive layer 112 may include the 2-2 electrode C22 of the second capacitor C2. The 2-2 electrode C22 of the second capacitor C2 may be a part of the second conductive layer 112. For example, the second conductive layer 112 and the 2-2 electrode C22 of the second capacitor C2 may be integrally formed (or integral) with each other. The 2-2 electrode C22 of the second capacitor C2 may overlap the 2-1 electrode C21. The second capacitor C2 may include the 2-1 electrode C21 and the 2-2 electrode C22.

Referring to FIG. 7, the sixth transistor T6 and the first capacitor C1 may be disposed on the substrate 100. The sixth transistor T6 may include the sixth semiconductor layer A6 including a silicon semiconductor material and the sixth gate electrode G6. The sixth semiconductor layer A6 may include the source region S6, the channel region CH6, and the drain region D6.

The first capacitor C1 may include the 1-1 electrode C11, the 1-2 electrode C12, and the 1-3 electrode C13. The 1-1 electrode C11, the 1-2 electrode C12, and the 1-3 electrode C13 may overlap each other. The 1-2 electrode C12 may be disposed over the 1-1 electrode C11 to overlap the 1-1 electrode C11. The 1-3 electrode C13 may be disposed over the 1-2 electrode C12 to overlap the 1-2 electrode C12.

The 1-1 electrode C11 of the first capacitor C1 may include a silicon semiconductor material. For example, the 1-1 electrode C11 of the first capacitor C1 may be a doped layer including a silicon semiconductor material. The 1-1 electrode C11 of the first capacitor C1 and the sixth semiconductor layer A6 of the sixth transistor T6 may be integrally connected to each other. For example, the 1-1 electrode C11 of the first capacitor C1 and the sixth semiconductor layer A6 of the sixth transistor T6 may be integrally formed (or integral) with each other.

The 1-2 electrode C12 of the first capacitor C1 and the sixth gate electrode G6 of the sixth transistor T6 may be disposed on the same layer. The 1-2 electrode C12 of the first capacitor C1 and the sixth gate electrode G6 of the sixth transistor T6 may include the same material.

In an embodiment, the second capacitor C2 may be disposed on the substrate 100. The second capacitor C2 may include the 2-1 electrode C21 and the 2-2 electrode C22. The 2-1 electrode C21 and the 2-2 electrode C22 may overlap each other. The 2-2 electrode C22 may be disposed over the 2-1 electrode C21 to overlap the 2-1 electrode C21.

The 2-1 electrode of the second capacitor C2 and the sixth gate electrode G6 of the sixth transistor T6 may be disposed on the same layer. The 2-1 electrode C21 of the second capacitor C2 and the sixth gate electrode G6 of the sixth transistor T6 may include the same material.

In a comparative example, in case that two electrodes of a first capacitor are formed by two metal layers disposed on a semiconductor layer, the size of the first capacitor was limited in case that the number of pixels per unit area was increased to increase the luminance of a display apparatus.

In an embodiment, the first capacitor C1 may include a doped semiconductor layer including a silicon semiconductor material, which functions as an electrode, and thus, the first capacitor C1 may include three electrodes. Because the first capacitor C1 includes a doped semiconductor layer and two metal layers disposed on the doped semiconductor layer as three electrodes, in case that the number of pixels per unit area of the display apparatus increases, there is no limitation on the capacity of the capacitor of the pixel circuit, and thus, the luminance and reliability of the display apparatus may be simultaneously improved.

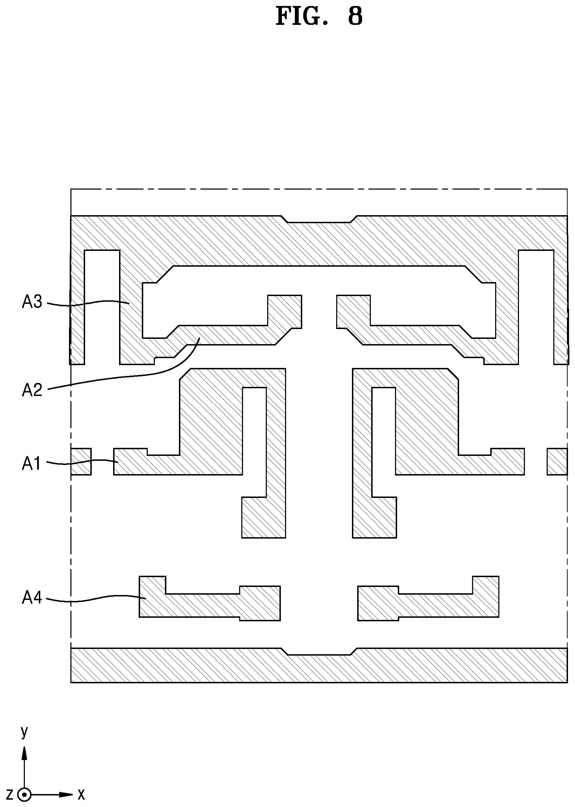

FIGS. 8 to 12 are schematic plan views illustrating a pixel circuit included in a display apparatus for each layer, according to an embodiment.

Referring to FIG. 8, a first semiconductor layer A1, a second semiconductor layer A2, a third semiconductor layer A3, and a fourth semiconductor layer A4 may be disposed on the substrate 100 (see FIG. 7). For example, the first semiconductor layer A1, the second semiconductor layer A2, the third semiconductor layer A3, and the fourth semiconductor layer A4 may be disposed on the same layer. The first semiconductor layer A1, the second semiconductor layer A2, the third semiconductor layer A3, and the fourth semiconductor layer A4 may include the same material. For example, the first semiconductor layer A1, the second semiconductor layer A2, the third semiconductor layer A3, and the fourth semiconductor layer A4 may be formed of a zinc (Zn) oxide-based material such as zinc (Zn) oxide, indium (In)-zinc (Zn) oxide, or gallium (Ga)-indium (In)-zinc (Zn) oxide. In another example, the first semiconductor layer A1, the second semiconductor layer A2, the third semiconductor layer A3, and the fourth semiconductor layer A4 may be formed of an indium gallium zinc oxide (IGZO) semiconductor including metals such as indium (In) and gallium (Ga) in ZnO.

The second semiconductor layer A2 and the third semiconductor layer A3 may be integrally formed (or integral) with each other. For example, the second semiconductor layer A2 and the third semiconductor layer A3 may be integrally connected to each other.

The first semiconductor layer A1 may be disposed adjacent to the second semiconductor layer A2 and the third semiconductor layer A3, but may be separated and spaced apart from the second semiconductor layer A2 and the third semiconductor layer A3. The first semiconductor layer A1 may have an isolated shape.

The fourth semiconductor layer A4 may be disposed adjacent to the first semiconductor layer A1, but may be separated and spaced apart from the first semiconductor layer A1. The fourth semiconductor layer A4 may have an isolated shape.

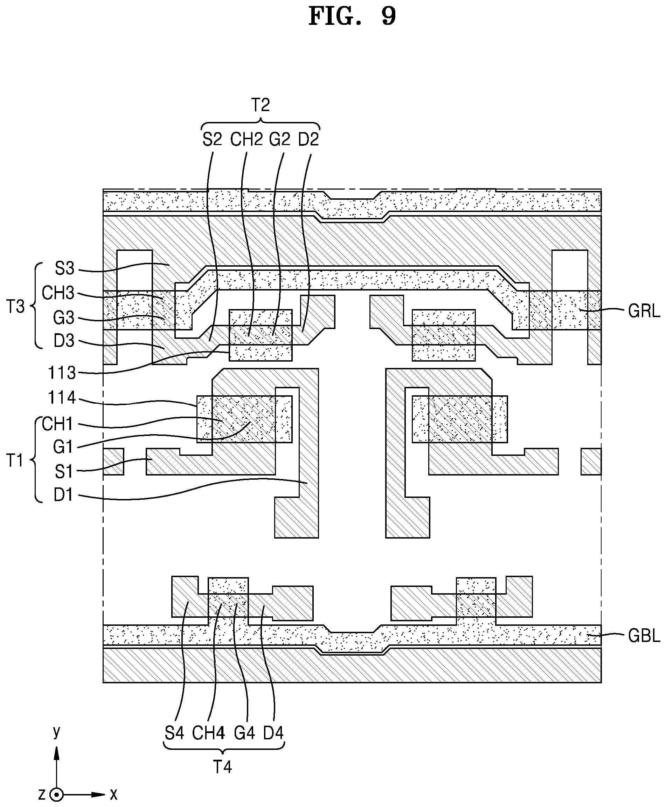

Referring to FIG. 9, a second gate line GRL, a fourth gate line GBL, a third conductive layer 113, and a fourth conductive layer 114 may be disposed on the first to fourth semiconductor layers A1, A2, A3, and A4. Each of the third conductive layer 113 and the fourth conductive layer 114 may have an isolated shape. The second gate line GRL and the fourth gate line GBL may extend in the first direction (e.g., the positive x direction or the negative x direction).

The second gate line GRL, the fourth gate line GBL, the third conductive layer 113, and the fourth conductive layer 114 may include the same material. For example, the second gate line GRL, the fourth gate line GBL, the third conductive layer 113, and the fourth conductive layer 114 may include molybdenum (Mo), aluminum (Al), copper (Cu), or titanium (Ti), and may have a single-layer structure or a multi-layer structure including the above material.

The second gate line GRL may include a third gate electrode G3 overlapping a channel region CH3 of a third transistor T3. The third semiconductor layer A3 described with reference to FIG. 8 may include the channel region CH3 overlapping the third gate electrode G3, a source region S3 disposed on a side of the channel region CH3, and a drain region D3 disposed on another side of the channel region CH3.

The third conductive layer 113 may include a second gate electrode G2 overlapping a channel region CH2 of a second transistor T2. The second semiconductor layer A2 described with reference to FIG. 8 may include the channel region CH2 overlapping the second gate electrode G2, a source region S2 disposed on a side of the channel region CH2, and a drain region D2 disposed on another side of the channel region CH2.

The fourth conductive layer 114 may include a first gate electrode G1 overlapping a channel region CH1 of a first transistor T1. The first semiconductor layer A1 described with reference to FIG. 8 may include the channel region CH1 overlapping the first gate electrode G1, a source region S1 disposed on a side of the channel region CH1, and a drain region D1 disposed on another side of the channel region CH1.

The fourth gate line GBL may include a fourth gate electrode G4 overlapping a channel region CH4 of a fourth transistor T4. The fourth semiconductor layer A4 described with reference to FIG. 8 may include the channel region CH4 overlapping the fourth gate electrode G4, a source region S4 disposed on a side of the channel region CH4, and a drain region D4 disposed on another side of the channel region CH4.

The second gate line GRL and the fourth gate line GBL may be disposed relatively far from each other. In some embodiments, the third conductive layer 113 and the fourth conductive layer 114 may be disposed between the second gate line GRL and the fourth gate line GBL.

For example, a transistor including a semiconductor layer including an oxide semiconductor material and a gate electrode overlapping the semiconductor layer may be disposed on a first capacitor C1. For example, a transistor including a semiconductor layer including an oxide semiconductor material and a gate electrode overlapping the semiconductor layer may be disposed on a second capacitor C2.

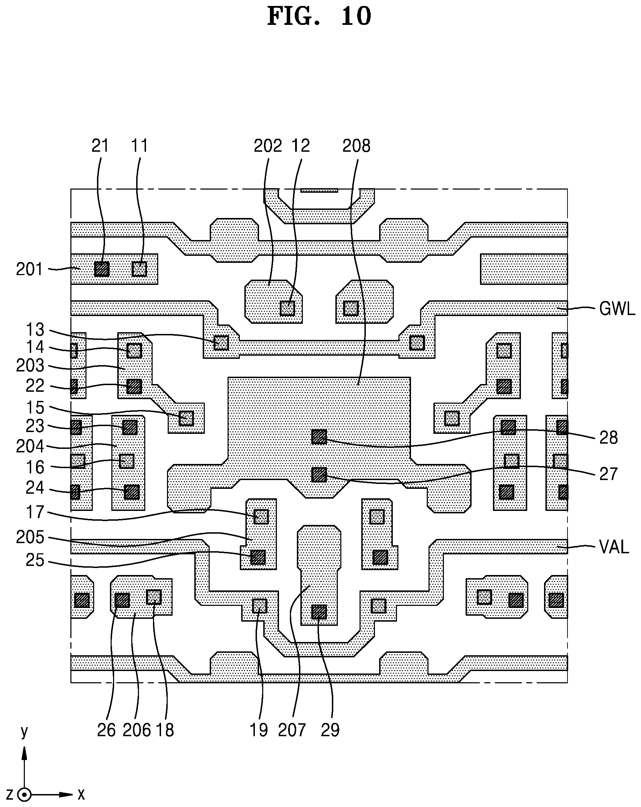

Referring to FIG. 10, first to eighth connection electrodes 201, 202, 203, 204, 205, 206, 207, and 208, a first gate line GWL, and a first initialization voltage line VAL may be disposed on the second gate line GRL, the fourth gate line GBL, the third conductive layer 113, and the fourth conductive layer 114. The first gate line GWL and the first initialization voltage line VAL may extend in the first direction (e.g., the positive x direction or the negative x direction). Each of the first to eighth connection electrodes 201, 202, 203, 204, 205, 206, 207, and 208 may have an isolated shape.

The first to eighth connection electrodes 201, 202, 203, 204, 205, 206, 207, and 208, the first gate line GWL, and the first initialization voltage line VAL may include the same material. For example, the first to eighth connection electrodes 201, 202, 203, 204, 205, 206, 207, and 208, the first gate line GWL, and the first initialization voltage line VAL may include molybdenum (Mo), aluminum (Al), copper (Cu), or titanium (Ti), and may have a single-layer structure or a multi-layer structure including the above material.

The first connection electrode 201 may electrically connect the source region S3 of the third transistor T3 to a reference voltage line VRL. The first connection electrode 201 may be connected to the source region S3 of the third transistor T3 through a contact hole 11 passing through at least one insulating layer disposed between the first connection electrode 201 and the source region S3 of the third semiconductor layer A3 of the third transistor T3. The first connection electrode 201 may be connected to the reference voltage line VRL through a contact hole 21 passing through at least one insulating layer disposed between the first connection electrode 201 and the reference voltage line VRL.

The second connection electrode 202 may be connected to the drain region D2 of the second transistor T2 through a contact hole 12 passing through at least one insulating layer disposed between the second connection electrode 202 and the second drain region D2 of the second semiconductor layer A2 of the second transistor T2.

The third connection electrode 203 may be connected to the second source region S2 of the second transistor T2 through a contact hole 14 passing through at least one insulating layer disposed between the third connection electrode 203 and the second source region S2 of the second transistor T2. The third connection electrode 203 may be connected to the third drain region D3 of the third transistor T3 through the contact hole 14 passing through at least one insulating layer disposed between the third connection electrode 203 and the third drain region D3 of the third transistor T3. The third connection electrode 203 may be connected to a first conductive layer 111 through a contact hole 22 passing through at least one insulating layer disposed between the third connection electrode 203 and the first conductive layer 111. The third connection electrode 203 may be connected to the fourth conductive layer 114 through a contact hole 15 passing through at least one insulating layer disposed between the third connection electrode 203 and the fourth conductive layer 114.

The fourth connection electrode 204 may be connected to the source region S6 of the sixth transistor T6 through a contact hole 23 passing through at least one insulating layer disposed between the fourth connection electrode 204 and the source region S6 of the sixth transistor T6. The fourth connection electrode 204 may be connected to the source region S1 of the first transistor T1 through a contact hole 16 passing through at least one insulating layer disposed between the fourth connection electrode 204 and the source region S1 of the first transistor T1. The fourth connection electrode 204 may be connected to a second conductive layer 112 through a contact hole 24 passing through at least one insulating layer disposed between the fourth connection electrode 204 and the second conductive layer 112.

The fifth connection electrode 205 may be connected to the drain region D1 of the first transistor T1 through a contact hole 17 passing through at least one insulating layer disposed between the fifth connection electrode 205 and the drain region D1 of the first transistor T1. The fifth connection electrode 205 may be connected to the source region S5 of the fifth transistor T5 through a contact hole 25 passing through at least one insulating layer disposed between the fifth connection electrode 205 and the source region S5 of the fifth transistor T5.

The sixth connection electrode 206 may be connected to the drain region D6 of the sixth transistor T6 through a contact hole 26 passing through at least one insulating layer disposed between the sixth connection electrode 206 and the drain region D6 of the sixth transistor T6. The sixth connection electrode 206 may be connected to the source region S4 of the fourth transistor T4 through a contact hole 18 passing through at least one insulating layer disposed between the sixth connection electrode 206 and the source region S4 of the fourth transistor T4.

The seventh connection electrode 207 may be connected to the reference voltage line VRL through a contact hole 29 passing through at least one insulating layer disposed between the seventh connection electrode 207 and the reference voltage line VRL.

The eighth connection electrode 208 may be connected to a driving voltage line PL through a contact hole 27 passing through at least one insulating layer disposed between the eighth connection electrode 208 and the driving voltage line PL. The eighth connection electrode 208 may be connected to the drain region D5 of the fifth transistor T5 through a contact hole 28 passing through at least one insulating layer disposed between the eighth connection electrode 208 and the drain region D5 of the fifth transistor T5.

The first gate line GWL and the third conductive layer 113 may be electrically connected to each other. The first gate line GWL may be connected to the third conductive layer 113 through a contact hole 13 passing through at least one insulating layer disposed between the first gate line GWL and the third conductive layer 113.

The first initialization voltage line VAL may be electrically connected to the drain region D4 of the fourth transistor T4. The first initialization voltage line VAL may be connected to the drain region D4 of the fourth transistor T4 through a contact hole 19 passing through at least one insulating layer disposed between the first initialization voltage line VAL and the drain region D4 of the fourth transistor T4.

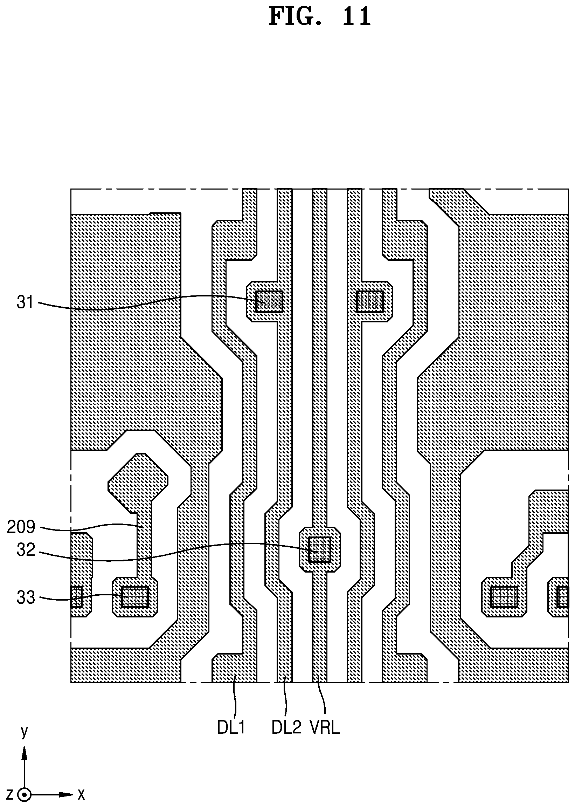

Referring to FIG. 11, a first data line DL1, a second data line DL2, the reference voltage line VRL, and a ninth connection electrode 209 may be disposed on the first to eighth connection electrodes 201, 202, 203, 204, 205, 206, 207, and 208, the first gate line GWL, and the reference voltage line VRL. The first data line DL1, the second data line DL2, and the reference voltage line VRL may extend in a second direction (e.g., a positive y direction or a negative y direction). The ninth connection electrode 209 may have an isolated shape.

The second data line DL2 may be connected to the second conductive layer 112 through a contact hole 31 passing through at least one insulating layer disposed between the second data line DL2 and the second conductive layer 112.

The reference voltage line VRL may be connected to the seventh connection electrode 207 through a contact hole 32 passing through at least one insulating layer disposed between the reference voltage line VRL and the seventh connection electrode 207.

The ninth connection electrode 209 may be connected to the sixth connection electrode 206 through a contact hole 33 passing through at least one insulating layer disposed between the ninth connection electrode 209 and the sixth connection electrode 206.

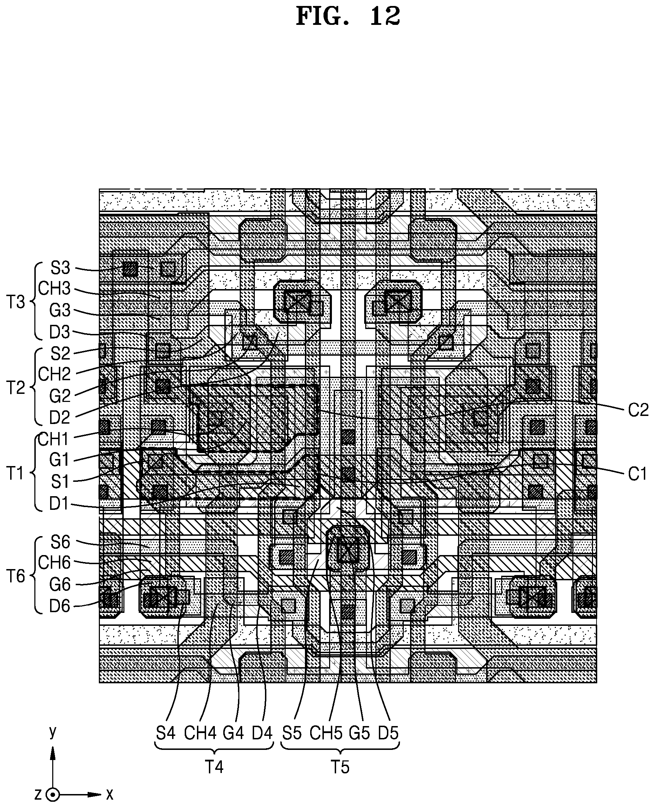

Referring to FIG. 12, first to sixth transistors T1, T2, T3, T4, T5, and T6, the first capacitor C1, and the second capacitor C2 included in a pixel circuit may be disposed on the substrate. FIG. 12 is a schematic plan view illustrating the fifth transistor T5 and the sixth transistor T6 including a silicon semiconductor material, the first to fourth transistors T1, T2, T3, and T4 including an oxide semiconductor material, the first capacitor C1, and the second capacitor C2.

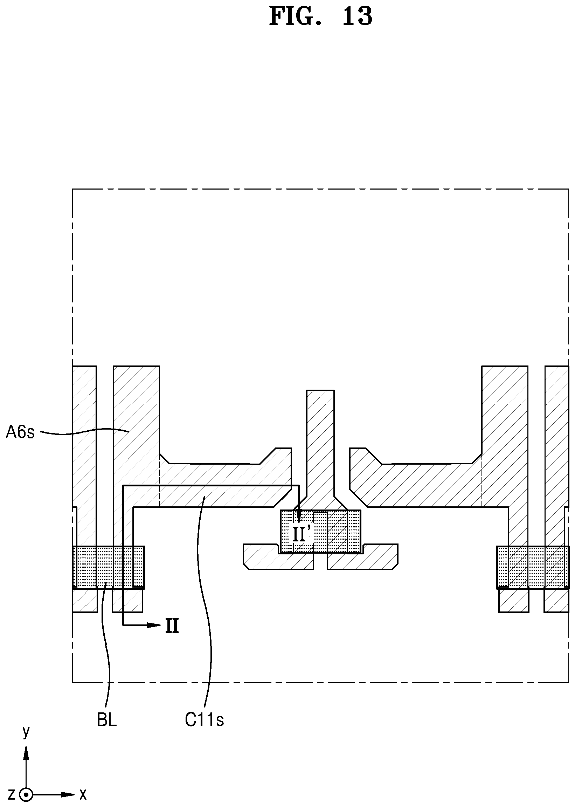

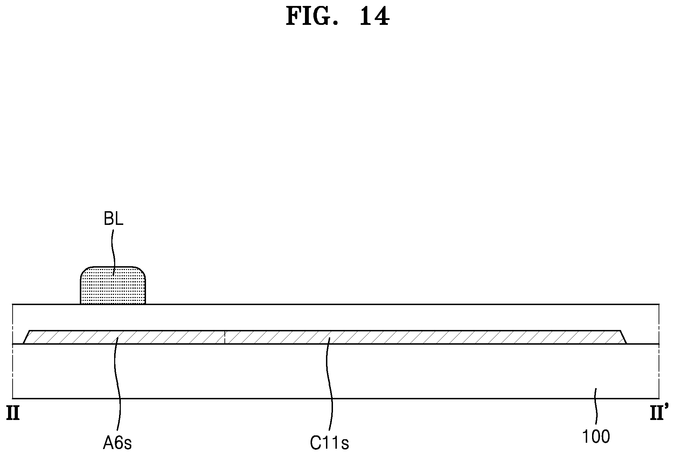

FIG. 13 is a schematic plan view illustrating a blocking layer disposed on at least a part of a semiconductor layer-forming material. FIGS. 14 to 17 are schematic cross-sectional views illustrating a method of manufacturing a transistor and a capacitor. For example, FIG. 14 is a schematic cross-sectional view taken along line II-II' of the display apparatus of FIG. 13.

Referring to FIGS. 13 and 14, a 1-1 electrode-forming material C11s of the first capacitor C1 including a silicon semiconductor material and a sixth semiconductor layer-forming material A6s may be disposed on the same layer on the substrate 100. The 1-1 electrode-forming material C11s of the first capacitor C1 and the sixth semiconductor layer-forming material A6s may be integrally formed (or integral) with each other. The 1-1 electrode-forming material C11s of the first capacitor C1 and the sixth semiconductor layer-forming material A6s may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In another embodiment, the 1-1 electrode-forming material C11s of the first capacitor C1 and the sixth semiconductor layer-forming material A6s may include polysilicon or amorphous silicon.

A blocking layer BL may be disposed on at least a part of the sixth semiconductor layer-forming material A6s. The blocking layer BL may include the same material as a photoresist used in a general process of manufacturing a display apparatus. However, embodiments are not limited thereto.

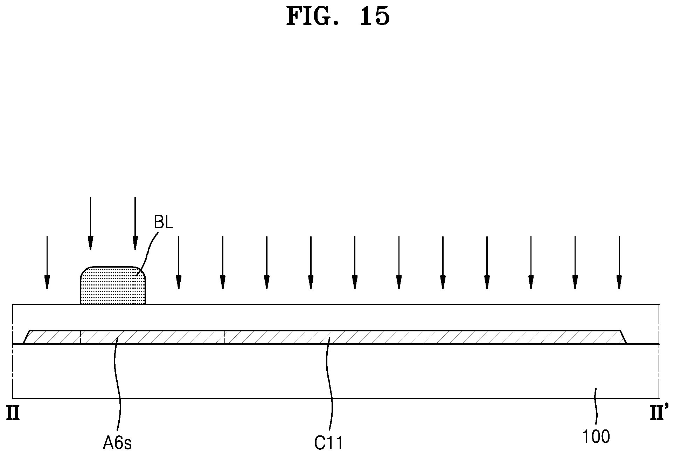

Referring to FIG. 15, the blocking layer BL may not be disposed on the 1-1 electrode-forming material C11s of the first capacitor C1. The 1-1 electrode C11 of the first capacitor C1 may be formed by doping the 1-1 electrode-forming material C11s of the first capacitor C1 on which the blocking layer BL is not disposed. The blocking layer BL may be removed after a process of doping the 1-1 electrode-forming material C11s of the first capacitor C1.

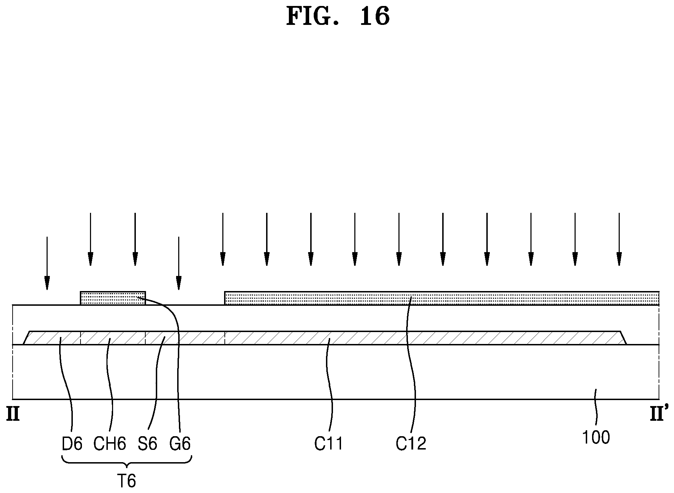

Referring to FIG. 16, the sixth gate electrode G6 and the 1-2 electrode C12 of the first capacitor C1 may be formed on at least a part of the sixth semiconductor layer-forming material A6s. The 1-2 electrode C12 may be formed over the 1-1 electrode C11 of the first capacitor C1 to overlap the 1-1 electrode C11. The 1-2 electrode C12 of the first capacitor C1 and the sixth gate electrode G6 of the sixth transistor T6 may be disposed on the same layer and may include the same material. The 1-2 electrode C12 of the first capacitor C1 may be simultaneously formed with the sixth gate electrode G6 of the sixth transistor T6. For example, the 1-2 electrode C12 of the first capacitor C1 and the sixth gate electrode G6 of the sixth transistor T6 may include molybdenum (Mo), aluminum (Al), copper (Cu), or titanium (Ti) and may have a single-layer structure or a multi-layer structure including the above material.

The sixth gate electrode G6 may not be disposed on at least a part of the sixth semiconductor layer-forming material A6s. The sixth semiconductor layer A6 may be formed by doping at least the part of the sixth semiconductor layer-forming material A6s on which the sixth gate electrode G6 is not disposed. For example, doped portions of the sixth semiconductor layer-forming material A6s may be the source region S6 and the drain region D6, and a portion, which overlaps the sixth gate electrode G6 and is not doped, may be the channel region CH6. The sixth semiconductor layer A6 may include the source region S6, the channel region CH6, and the drain region D6. The sixth transistor T6 may include the sixth semiconductor layer A6 and a gate electrode overlapping the sixth semiconductor layer A6.

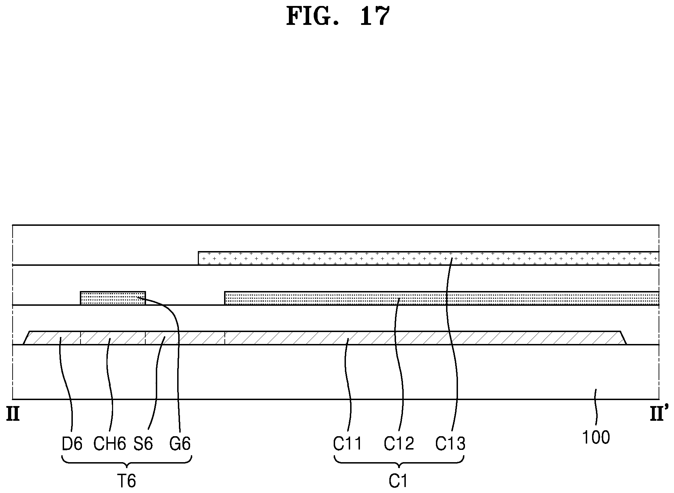

Referring to FIG. 17, the 1-3 electrode C13 may be formed over the 1-2 electrode C12 of the first capacitor C1 to overlap the 1-2 electrode C12. The first capacitor C1 may include the 1-1 electrode C11, the 1-2 electrode C12, and the 1-3 electrode C13 overlapping each other.

In a comparative example, in case that there is no doping process after the blocking layer BL is disposed on at least a part of the sixth semiconductor layer-forming material A6s, because doping is performed after the sixth gate electrode G6, the third gate line EML (see FIG. 5), and the driving voltage line PL (see FIG. 5) are formed on the sixth semiconductor layer-forming material A6s, a portion of the sixth semiconductor layer A6 overlapping the sixth gate electrode G6, the third gate line EML, and the driving voltage line PL may be an undoped channel region, and thus, any part of a layer including the sixth semiconductor layer A6 may not be used as a wiring.

In an embodiment, before the sixth gate electrode G6 is formed on at least a part of the sixth semiconductor layer-forming material A6s and doping is performed, the blocking layer BL may be formed on at least a part of the sixth semiconductor layer-forming material A6s and then doping may be performed to form the 1-1 electrode C11 of the first capacitor C1. Because the 1-1 electrode-forming material C11s is doped after the blocking layer BL is disposed on at least a part of the sixth semiconductor layer-forming material A6s, the 1-1 electrode C11 of the first capacitor C1 integrally formed (or integral) with the sixth semiconductor layer A6 may be formed. Because the first capacitor C1 includes three electrodes including a doped layer including a silicon semiconductor material and two metal layers on the doped layer, in case that the number of pixels per unit area of the display apparatus increases, there may be no limitation on the capacity of the capacitor of the pixel circuit, thereby improving the luminance and reliability of the display apparatus.

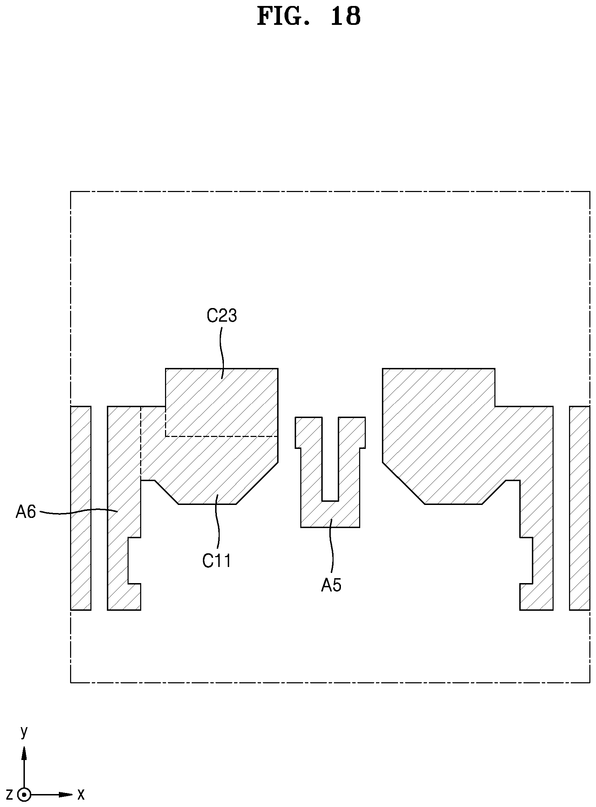

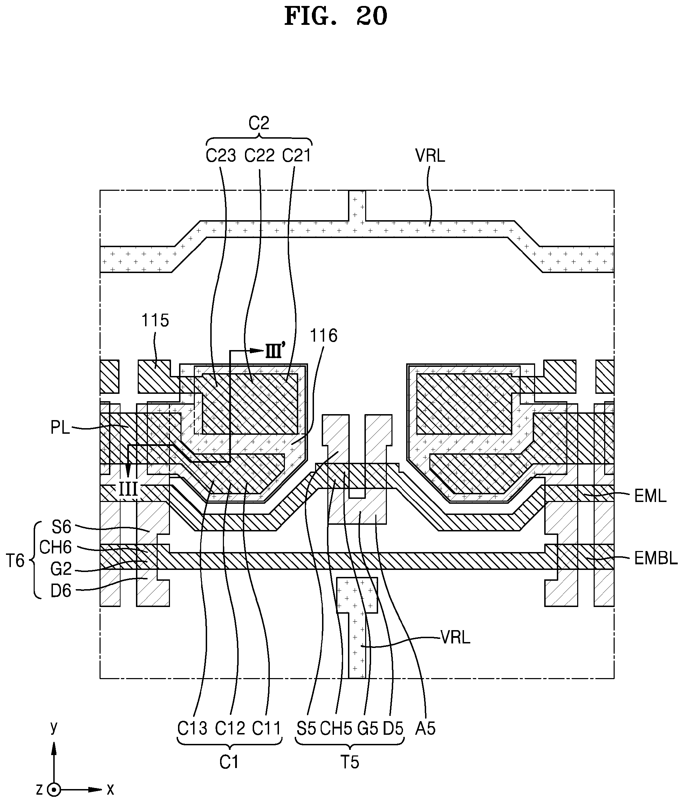

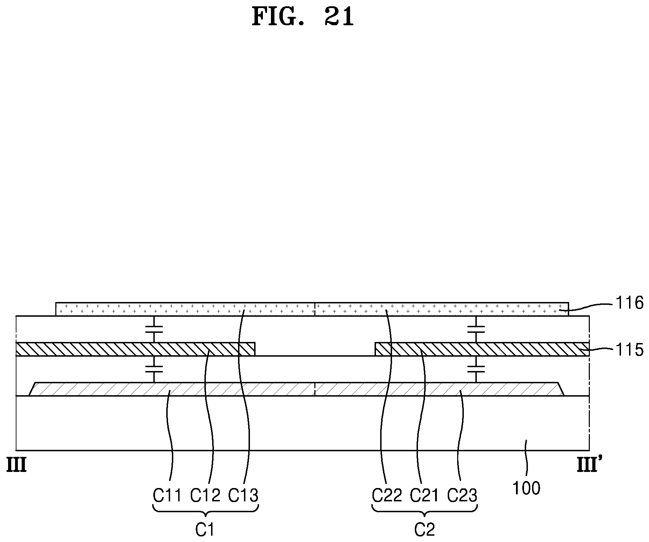

FIGS. 18 to 20 are schematic plan views illustrating a process of forming a pixel circuit included in a display apparatus, according to an embodiment. FIG. 21 is a schematic cross-sectional view taken along line III-III' of the display apparatus of FIG. 20.

Referring to FIG. 18, a fifth semiconductor layer A5, a sixth semiconductor layer A6, a 1-1 electrode C11 of a first capacitor C1, and a 2-3 electrode C23 of a second capacitor C2 may be disposed on the substrate 100 (see FIG. 21). For example, the fifth semiconductor layer A5, the sixth semiconductor layer A6, the 1-1 electrode C11 of the first capacitor C1, and the 2-3 electrode C23 of the second capacitor C2 may be disposed on the same layer. The fifth semiconductor layer A5, the sixth semiconductor layer A6, the 1-1 electrode C11 of the first capacitor C1, and the 2-3 electrode C23 of the second capacitor C2 may include the same material. For example, the fifth semiconductor layer A5, the sixth semiconductor layer A6, the 1-1 electrode C11 of the first capacitor C1, and the 2-3 electrode C23 of the second capacitor C2 may include a silicon semiconductor material. For example, the fifth semiconductor layer A5, the sixth semiconductor layer A6, the 1-1 electrode C11 of the first capacitor C1, and the 2-3 electrode C23 of the second capacitor C2 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In another embodiment, the fifth semiconductor layer A5, the sixth semiconductor layer A6, the 1-1 electrode C11 of the first capacitor C1, and the 2-3 electrode C23 of the second capacitor C2 may include polysilicon or amorphous silicon.

The sixth semiconductor layer A6, the 1-1 electrode C11 of the first capacitor C1, and the 2-3 electrode C23 of the second capacitor C2 may be integrally formed (or integral) with each other. For example, the sixth semiconductor layer A6, the 1-1 electrode C11 of the first capacitor C1, and the 2-3 electrode C23 of the second capacitor C2 may be integrally connected to each other. The fifth semiconductor layer A5 may be disposed adjacent to the sixth semiconductor layer A6, the 1-1 electrode C11 of the first capacitor C1, and the 2-3 electrode C23 of the second capacitor C2, but may be separated and spaced apart from the sixth semiconductor layer A6, the 1-1 electrode C11 of the first capacitor C1, and the 2-3 electrode C23 of the second capacitor C2.

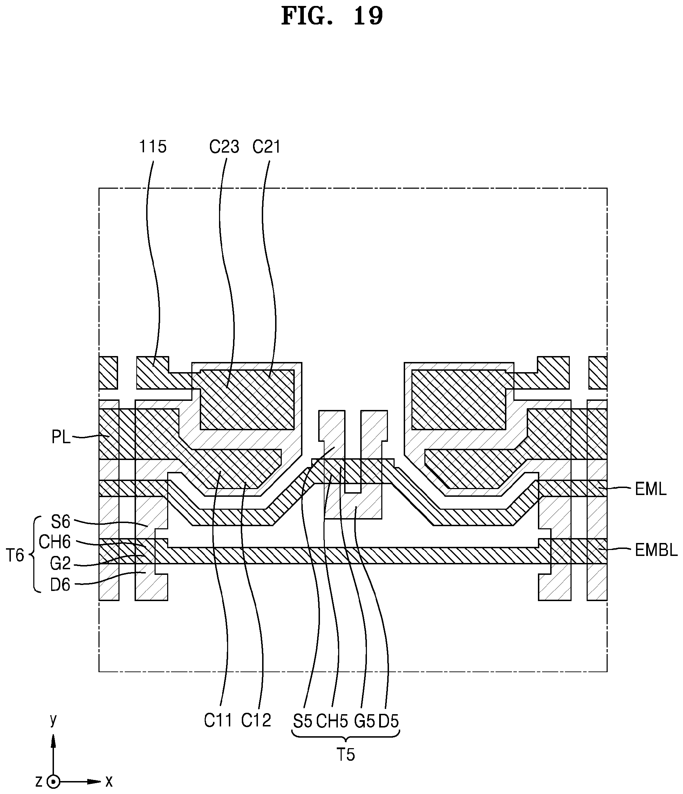

Referring to FIG. 19, a third gate line EML, a fifth gate line EMBL, a driving voltage line PL, and a fifth conductive layer 115 may be disposed on the fifth semiconductor layer A5, the sixth semiconductor layer A6, the 1-1 electrode C11 of the first capacitor C1, and the 2-3 electrode C23 of the second capacitor C2. Each of the fifth conductive layer 115 and the driving voltage line PL may have an isolated shape. The third gate line EML and the fifth gate line EMBL may extend in the first direction (e.g., the positive x direction or the negative x direction).

The third gate lime EML, the fifth gate line EMBL, the driving voltage line PL, and the fifth conductive layer 115 may include the same material. For example, the third gate lime EML, the fifth gate line EMBL, the driving voltage line PL, and the fifth conductive layer 115 may include molybdenum (Mo), aluminum (Al), copper (Cu), or titanium (Ti), and may have a single-layer structure or a multi-layer structure including the above material.

The driving voltage line PL may include a 1-2 electrode C12 of the first capacitor C1. The 1-2 electrode C12 of the first capacitor C1 may be a part of the driving voltage line PL. For example, the driving voltage line PL and the 1-2 electrode C12 of the first capacitor C1 may be integrally formed (or integral) with each other. The 1-2 electrode C12 of the first capacitor C1 may overlap the 1-1 electrode C11 of the first capacitor C1.

The fifth conductive layer 115 may include a 2-1 electrode C21 of the second capacitor C2. The 2-1 electrode C21 of the second capacitor C2 may be a part of the fifth conductive layer 115. For example, the fifth conductive layer 115 and the 2-1 electrode C21 of the second capacitor C2 may be integrally formed (or integral) with each other. The 2-1 electrode C21 of the second capacitor C2 may be disposed over the 2-3 electrode C23 to overlap the 2-3 electrode C23.

The third gate line EML may include a fifth gate electrode G5 overlapping a channel region CH5 of a fifth transistor T5. The fifth semiconductor layer A5 described with reference to FIG. 4 may include the channel region CH5 overlapping the fifth gate electrode G5, a source region S5 disposed on a side of the channel region CH5, and a drain region D5 disposed on another side of the channel region CH5.

The fifth gate line EMBL may include a sixth gate electrode G6 overlapping a channel region CH6 of a sixth transistor T6. The sixth semiconductor layer A6 described with reference to FIG. 4 may include the channel region CH6 overlapping the sixth gate electrode G6, a source region S6 disposed on a side of the channel region CH6, and a drain region D6 disposed on another side of the channel region CH6.

The third gate line EML may be disposed relatively far from the fifth conductive layer 115. In some embodiments, the fifth gate line EMBL and the driving voltage line PL may be disposed between the third gate line EML and the fifth conductive layer 115.

Referring to FIG. 20, a reference voltage line VRL and a sixth conductive layer 116 may be disposed on the third gate line EML, the fifth gate line EMBL, the driving voltage line PL, and the fifth conductive layer 115. The sixth conductive layer 116 may have an isolated shape. The reference voltage line VRL may extend in the first direction (e.g., the positive x direction or the negative x direction).

The sixth conductive layer 116 may include a 1-3 electrode C13 of the first capacitor C1. The 1-3 electrode C13 of the first capacitor C1 may be a part of the sixth conductive layer 116. For example, the sixth conductive layer 116 and the 1-3 electrode C13 of the first capacitor C1 may be integrally formed (or integral) with each other. The 1-3 electrode C13 of the first capacitor C1 may overlap the 1-1 electrode C11 and the 1-2 electrode C12. The first capacitor C1 may include the 1-1 electrode C11, the 1-2 electrode C12, and the 1-3 electrode C13.

The sixth conductive layer 116 may include a 2-2 electrode C22 of the second capacitor C2. The 2-2 electrode C22 of the second capacitor C2 may be a part of the sixth conductive layer 116. For example, the sixth conductive layer 116 and the 2-2 electrode C22 of the second capacitor C2 may be integrally formed (or integral) with each other. The 2-2 electrode C22 of the second capacitor C2 may overlap the 2-3 electrode C23 and the 2-1 electrode C21. The second capacitor C2 may include the 2-1 electrode C21, the 2-2 electrode C22, and the 2-3 electrode C23.

Referring to FIG. 21, the first capacitor C1 and the second capacitor C2 may be disposed on the substrate 100. The first capacitor C1 may include the 1-1 electrode C11, the 1-2 electrode C12, and the 1-3 electrode C13 overlapping each other. The second capacitor C2 may include the 2-1 electrode C21, the 2-2 electrode C22, and the 2-3 electrode C23 overlapping each other.

The 1-1 electrode C11 of the first capacitor C1 and the 2-3 electrode C23 of the second capacitor C2 may be disposed on the same layer and may include the same material. The 1-1 electrode C11 of the first capacitor C1 and the 2-3 electrode C23 of the second capacitor C2 may include a silicon semiconductor material. The 1-1 electrode C11 of the first capacitor C1 and the 2-3 electrode C23 of the second capacitor C2 may be a doped layer including a silicon semiconductor material.

The 1-2 electrode C12 of the first capacitor C1 may be disposed over the 1-1 electrode C11 to overlap the 1-1 electrode C11. The 2-1 electrode C21 of the second capacitor may be disposed over the 2-3 electrode C23 to overlap the 2-3 electrode C23. The 2-3 electrode C23 of the second capacitor C2 may be disposed under the 2-1 electrode C21 to overlap the 2-1 electrode C21. The 1-2 electrode C12 of the first capacitor C1 and the 2-1 electrode C21 of the second capacitor C2 may be disposed on the same layer and may include the same material.

The 1-3 electrode C13 of the first capacitor C1 may be disposed over the 1-2 electrode C12 to overlap the 1-2 electrode C12. The 2-2 electrode C22 of the second capacitor C2 may be disposed over the 2-1 electrode C21 to overlap the 2-1 electrode C21. The 1-3 electrode C13 of the first capacitor C1 and the 2-2 electrode C22 of the second capacitor C2 may be disposed on the same layer and may include the same material. The 1-3 electrode C13 of the first capacitor C1 and the 2-2 electrode C22 of the second capacitor C2 may be integrally formed (or integral) with each other. However, embodiments are not limited thereto.

In an embodiment, not only the first capacitor C1 but also the second capacitor C2 may include a doped layer including a silicon semiconductor material as an electrode, and the first capacitor C1 and the second capacitor C2 may include three electrodes. Because the first capacitor C1 and the second capacitor C2 includes three electrodes including a doped semiconductor layer and two metal layers disposed on the doped semiconductor layer, in case that the number of pixels per unit area of the display apparatus increases, there may be no limitation on the capacity of the capacitor of the pixel circuit, thereby improving the luminance and reliability of the display apparatus.

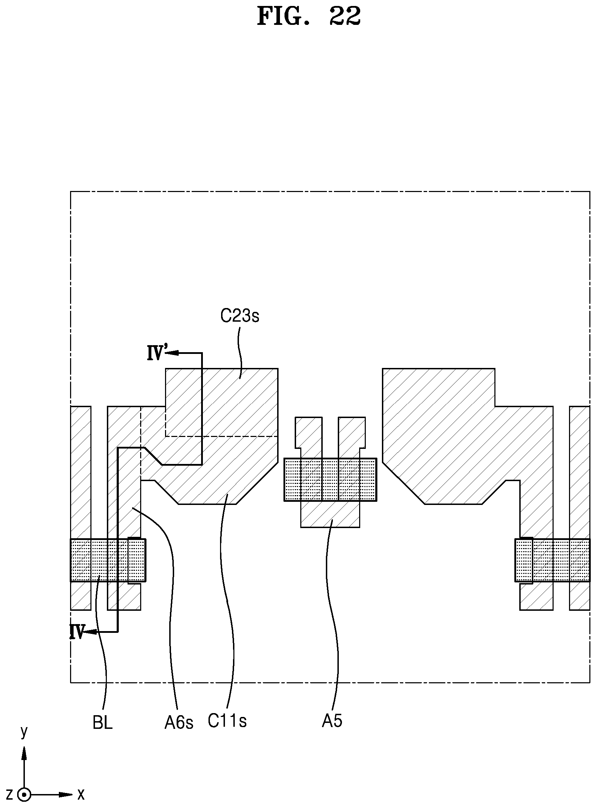

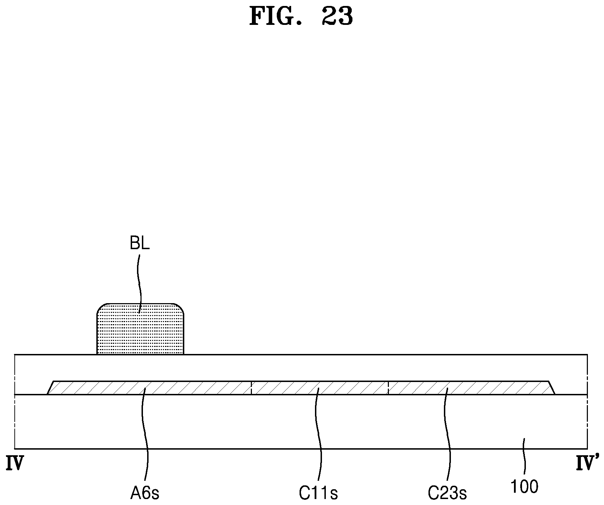

FIG. 22 is a schematic plan view illustrating a blocking layer disposed on at least a part of a semiconductor layer. FIGS. 23 to 25 are schematic plan views illustrating part of a method of manufacturing a sixth transistor, a first capacitor, and a second capacitor. For example, FIG. 23 is a schematic cross-sectional view taken along line IV-IV' of the display apparatus of FIG. 22.

Referring to FIGS. 22 and 23, the sixth semiconductor layer-forming material A6s including a silicon semiconductor material, the 1-1 electrode-forming material C11s of the first capacitor C1, and a 2-3 electrode-forming material C23s of the second capacitor C2 may be disposed on the same layer on the substrate 100. The sixth semiconductor layer-forming material A6s, the 1-1 electrode-forming material C11s of the first capacitor C1, and the 2-3 electrode-forming material C23s of the second capacitor C2 may be integrally formed (or integral) with each other. The sixth semiconductor layer-forming material A6s, the 1-1 electrode-forming material C11s of the first capacitor C1, and the 2-3 electrode-forming material C23s of the second capacitor C2 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In another embodiment, the sixth semiconductor layer-forming material A6s, the 1-1 electrode-forming material C11s of the first capacitor C1, and the 2-3 electrode-forming material C23s of the second capacitor C2 may include polysilicon or amorphous silicon.

The blocking layer BL may be disposed on at least a part of the sixth semiconductor layer-forming material A6s. The blocking layer BL may include the same material as a photoresist used in a general process of manufacturing a display apparatus. However, embodiments are not limited thereto.

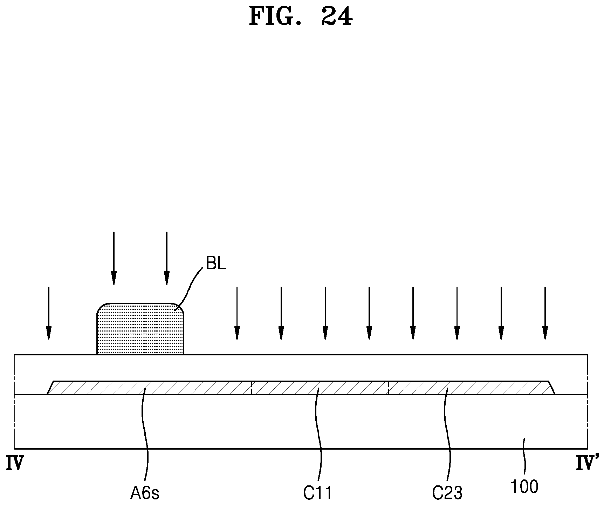

Referring to FIG. 24, the blocking layer BL may not be disposed on the 1-1 electrode-forming material C11s of the first capacitor C1 and the 2-3 electrode-forming material C23s of the second capacitor C2. The 1-1 electrode C11 of the first capacitor C1 and the 2-3 electrode C23 of the second capacitor C2 may be formed by doping the 1-1 electrode-forming material C11s of the first capacitor C1 and the 2-3 electrode-forming material C23s of the second capacitor C2 on which the blocking layer BL is not formed. The blocking layer BL may be removed after a process of doping the 1-1 electrode C11 of the first capacitor C1 and the 2-3 electrode C23 of the second capacitor C2.

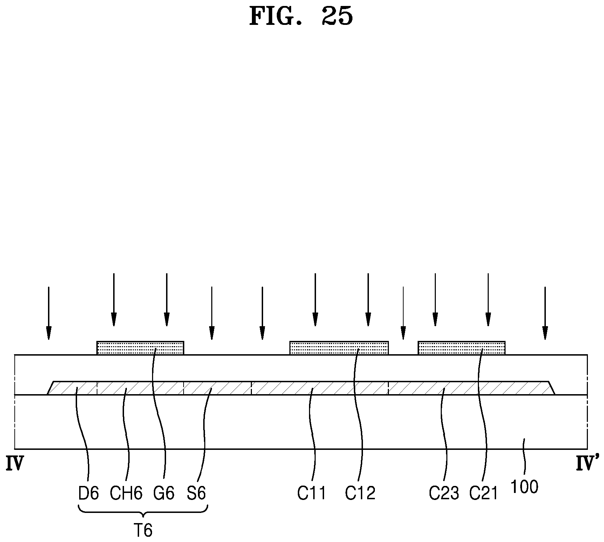

Referring to FIG. 25, the sixth gate electrode G6 may be formed on at least a part of the sixth semiconductor layer-forming material A6s. The sixth gate electrode G6 may not be disposed on at least a part of the sixth semiconductor layer-forming material A6s. The sixth semiconductor layer A6 may be formed by doping the at least part of the sixth semiconductor layer-forming material A6s on which the sixth gate electrode G6 is not disposed. For example, doped portions of the sixth semiconductor layer-forming material A6s may be the source region S6 and the drain region D6, and a portion, which overlaps the sixth gate electrode G6 and is not doped, may be the channel region CH6.

While the sixth semiconductor layer A6 is formed, the sixth transistor T6 may be formed. The sixth transistor T6 may include the sixth semiconductor layer A6 and the sixth gate electrode G6 overlapping the sixth semiconductor layer A6.

While the sixth gate electrode G6 is formed on at least a part of the sixth semiconductor layer-forming material A6s, the 1-2 electrode C12 may be disposed over the 1-1 electrode C11 of the first capacitor C1, and the 2-1 electrode C21 may be formed over the 2-3 electrode C23 of the second capacitor C2. The 1-2 electrode C12 of the first capacitor C1, the 2-1 electrode C21 of the second capacitor C2, and the sixth gate electrode G6 of the sixth transistor T6 may include the same material. The 1-2 electrode C12 of the first capacitor C1, the 2-1 electrode C21 of the second capacitor C2, and the sixth gate electrode G6 of the sixth transistor T6 may be simultaneously formed.

The 1-2 electrode C12 of the first capacitor C1 may be disposed over the 1-1 electrode C11 to overlap the 1-1 electrode C11. The 2-1 electrode C21 of the second capacitor C2 may be disposed over the 2-3 electrode C23 to overlap the 2-3 electrode C23.

The 1-3 electrode C13 may be disposed over the 1-2 electrode C12 of the first capacitor C1 to overlap the 1-2 electrode C12 and the 1-1 electrode C11. The 2-2 electrode C22 may be disposed over the 2-1 electrode C21 of the second capacitor C2 to overlap the 2-1 electrode C21 and the 2-3 electrode C23. The 1-3 electrode C13 of the first capacitor C1 and the 2-2 electrode C22 of the second capacitor C2 may be disposed on the same layer and may include the same material.

The first capacitor C1 may include the 1-1 electrode C11, the 1-2 electrode C12, and the 1-3 electrode C13 overlapping each other. The second capacitor C2 may include the 2-1 electrode C21, the 2-2 electrode C22, and the 2-3 electrode C23 overlapping each other.

In an embodiment, the first capacitor C1 may include a doped semiconductor layer including a silicon semiconductor material, which functions as an electrode, and the first capacitor C1 may include three electrodes. Because the first capacitor C1 includes three electrodes including a doped semiconductor layer and two metal layers disposed on the doped semiconductor layer, in case that the number of pixels per unit area of the display apparatus increases, there may be no limitation on the capacity of the capacitor of the pixel circuit, thereby improving the luminance and reliability of the display apparatus.

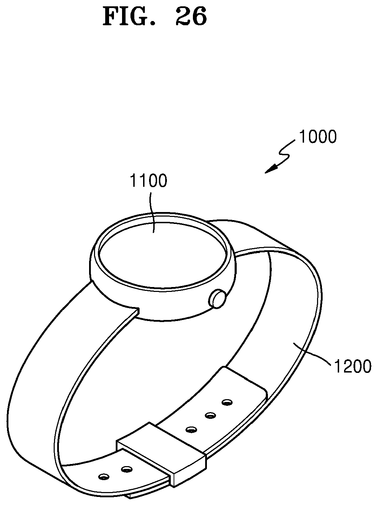

Referring to FIG. 26, the electronic device may be applied to a smart watch 1000 including a display part 1100 and a strap part 1200.

The smart watch 1000 may be a wearable electronic device. For example, the smart watch 1000 may have a structure in which the strap part 1200 is mounted on a wrist of a user. The electronic device may be applied to the display part 1100, so that image data including time information can be provided to the user.

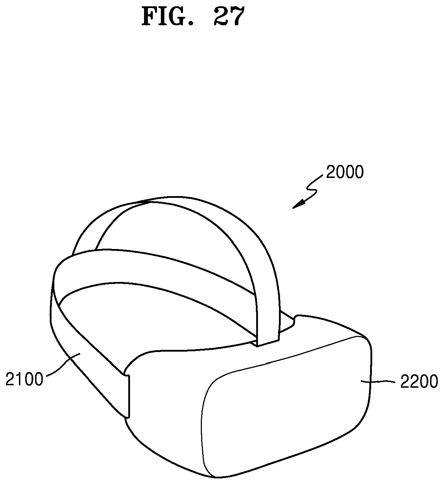

Referring to FIG. 27, the electronic device may be applied to a head mounted display device 2000.

The head mounted display device 2000 may be a wearable electronic device which can be worn on the head of a user. For example, the head mounted display device 2000 may be a wearable device for virtual reality (VR) or mixed reality (MR). The head mounted display device 2000 may include a head mounted band 2100 and a display accommodating case 2200. The head mounted band 2100 may be connected to the display accommodating case 2200. The head mounted band 2100 may include a horizontal band and/or a vertical band, used to fix the head mounted display device 2000 to the head of the user. The horizontal band may be configured to surround a side portion of the head of the user, and the vertical band may be configured to surround an upper portion of the head of the user. However, embodiments are not limited thereto. For example, the head mounted band 2100 may be implemented in the form of a glasses frame, a helmet or the like within the scope of the disclosure as defined by the appended claims.

For example, the electronic device may be at least one of televisions, notebook computers, monitors, advertisement boards, Internet of things (IoTs), portable electronic apparatuses including mobile phones, smartphones, tablet personal computers (PCs), mobile communication terminals, electronic organizers, electronic books, portable multimedia players (PMPs), navigations, ultra mobile personal computers (UMPCs), smartwatches, watchphones, glasses-type displays, head-mounted displays (HMDs), instrument panels for automobiles, center fascias for automobiles, or center information displays (CIDs) on a dashboard, room mirror displays of automobiles, and displays of an entertainment system on a backside of front seats in automobiles.

While the disclosure has been particularly shown and described with reference to embodiments thereof, they are provided for the purposes of illustration and it will be understood by one of ordinary skill in the art that various modifications and equivalent other embodiments made be made from the disclosure. Accordingly, the true technical scope of the disclosure is defined by the technical scope of the appended claims.

According to an embodiment as described above, a display apparatus with improved reliability and quality and a method of manufacturing the display apparatus may be provided. However, the scope of the disclosure is not limited by this effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope of the disclosure as defined by the appended claims.

## Claims

1. A display apparatus (1) comprising:
a first transistor (T6) disposed on a substrate (100) and comprising a first semiconductor layer (A6) and a first gate electrode (G6) overlapping the first semiconductor layer (A6), the first semiconductor layer (A6) comprising a silicon semiconductor material; and
a first capacitor (C1) disposed on the substrate (100),
wherein the first capacitor (C1) comprises:
a 1-1 electrode (C11) comprising a silicon semiconductor material;
a 1-2 electrode (C12) overlapping the 1-1 electrode (C11), the 1-2 electrode (C12) and the first gate electrode (G6) disposed on a same layer and comprising a same material; and
a 1-3 electrode (C13) overlapping the 1-2 electrode (C12).

2. The display apparatus (1) of claim 1,
wherein the 1-1 electrode (C11) of the first capacitor (C1) is a doped layer comprising a silicon semiconductor material; and/or
wherein the 1-1 electrode (C11) and the first semiconductor layer (A6) are integral with each other.

3. The display apparatus (1) of claim 1 or 2,
wherein the 1-2 (C12) electrode is disposed over the 1-1 electrode (C11); and/or
wherein the 1-3 (C13) electrode is disposed over the 1-2 electrode (C12).

4. The display apparatus (1) of any one of the preceding claims, further comprising:
a second transistor (T1) disposed on the first capacitor (C1) and comprising a second semiconductor layer (A1) and a second gate electrode (G1) overlapping the second semiconductor layer (A1),
wherein the second semiconductor layer (A1) comprises an oxide semiconductor material.

5. The display apparatus (1) of any one of the preceding claims, further comprising:
a second capacitor (C2) disposed on the substrate (100),
wherein the second capacitor (C2) comprises:
a 2-1 electrode (C21); and
a 2-2 electrode (C22) overlapping the 2-1 electrode (C21), and
the 2-1 electrode (C21) and the first gate electrode (G6) are disposed on a same layer, and comprise a same material.

6. The display apparatus (1) of claim 5, wherein the 2-2 electrode (C22) is disposed over the 2-1 electrode (C21).

7. The display apparatus (1) of claim 5 or 6, further comprising:
a 2-3 electrode (C23) disposed under the 2-1 electrode (C21) to overlap the 2-1 electrode (C21).

8. The display apparatus (1) of claim 7,
wherein the 2-3 electrode (C23) and the first semiconductor layer (A6) of the first transistor (T6) comprise a same material, and are disposed on a same layer; and/or
wherein the 2-3 electrode (C23) comprises a silicon semiconductor material; and/or
wherein the 2-3 electrode (C23) is a doped layer comprising a silicon semiconductor material.

9. A method of manufacturing a display apparatus (1), the method comprising:
arranging, on a substrate (100), a material for forming a 1-1 electrode (C11) of a first capacitor (C1) and a material for forming a first semiconductor layer (A6), the material for forming a 1-1 electrode (C11) of the first capacitor (C1) and the material for forming a first semiconductor layer (A6) comprising a silicon semiconductor material;
arranging a blocking layer (BL) on at least a part of the material for forming a first semiconductor layer (A6); and
forming a 1-1 electrode (C11) of the first capacitor (C1) by doping the material for forming a 1-1 electrode (C11) on which the blocking layer (BL) is not arranged.

10. The method of claim 9, further comprising:
removing the blocking layer (BL);
forming a first gate electrode (G6) on at least a part of the material for forming a first semiconductor layer (A6); and
forming a first semiconductor layer (A6) by doping at least a part of the material for forming a first semiconductor layer (A6) on which the first gate electrode (G6) is not arranged.

11. The method of claim 10, wherein a first transistor (T6) comprises the first semiconductor layer (A6) and the first gate electrode (G6) overlapping the first semiconductor layer (A6).

12. The method of claim 10 or 11, further comprising:
forming a 1-2 electrode (C12) on the 1-1 electrode (C11) of the first capacitor (C1) to overlap the 1-1 electrode (C11).

13. The method of any one of claims 10 to 12, wherein the 1-2 electrode (C12) of the first capacitor (C1) and the first gate electrode (G6) are disposed on a same layer and comprise a same material.

14. The method of any one of claims 9 to 13,
wherein the material for forming a 1-1 electrode (C11) of the first capacitor (C1) and the material for forming a first semiconductor layer (A6) are disposed on a same layer; and/or
wherein the 1-1 electrode (C11) of the first capacitor (C1) and the first semiconductor layer (A6) are integral with each other.

15. An electronic device (1000, 2000) comprising a display apparatus (1) of any one of claims 1 to 8.
